**Europäisches Patentamt**

**European Patent Office**

**Office européen des brevets**

(19)

(11) Publication number : **0 407 685 B1**

# (12) EUROPEAN PATENT SPECIFICATION

(45) Date of publication of patent specification :
28.06.95 Bulletin 95/26

(21) Application number : 90103236.7

(22) Date of filing : 20.02.90

(51) Int. Cl.⁶ : **G01N 23/04, G01N 23/18**

(54) Method for inspection of solder joints by x-ray fluoroscopic image and apparatus therefor.

(30) Priority : **14.07.89 JP 180305/89**

(43) Date of publication of application :
**16.01.91 Bulletin 91/03**

(45) Publication of the grant of the patent :
**28.06.95 Bulletin 95/26**

(84) Designated Contracting States :
**DE FR GB**

(56) References cited :
EP-A- 0 223 544
EP-A- 0 236 001
EP-A- 0 263 943
WO-A-89/04477
CA-A- 1 219 082
US-A- 4 688 175
US-A- 4 772 125
PROCEEDINGS OF THE SOCIETY OF PHOTO-OPTICAL INSTRUMENTATION ENGINEERS vol. 850, 1988, pages 93-100, Redondo Beach, CA, US; R.A. KUNTZ et al.: "Automatic SMT inspection with x-ray vision"
ELECTRONIC PACKAGING AND PRODUCTION vol. 25, June 1985, pages 98-104, Newton, MA, US; R. POUND: "Image processing boosts the power of nondestructive testing"
IEEE TRANSACTION ON PATTERN ANALYSIS AND MACHINE INTELLIGENCE vol. 10, no. 1, January 1988, pages 79-91; New York, US; H. BOERNER et al.: "Automated x-ray inspection of aluminium castings"
PROCEEDINGS OF THE FIFTH IEEE/CHMT INTERNAIONAL ELECTRONIC TECHNOLOGY SYMPOSIUM: "Design-to-Manufacturing Transfer Cycle" 1988, pages 215-220, New York, US; J. HUDZIK: "SMT statistical process control using automatic x-ray inspection"
SYSTEMS & COMPUTERS IN JAPAN vol. 17, no. 5, May 1986, pages 54-63, New York, US; Y. SHIMA et al.: "An automatic visual inspection method for a plastic surface based on image parititioning and gray-level histograms"

(56) References cited :
ELECTRONICS vol. 58, no. 28, 15 July 1985, pages 48-52, New York, US; H. BIERMAN: "Packaging changes make automatic testing tougher, more costly"
INSPEC DATABASE abstract no. B88063070, Institute of Electrical Engineers, London, GB; D. THOMPSON et al.: "Designing electronics for automated inspection"; & Circuit World 1988, vol. 14, no. 4, pages 13-20

(73) Proprietor : HITACHI, LTD.
6, Kanda Surugadai 4-chome
Chiyoda-ku, Tokyo 101 (JP)

(72) Inventor : Hamada, Toshimitsu,
Sanhaitsutotsuka 103
2007-27 Kamikurata-cho,
Totsuka-ku
Yokohama-shi, Kanagawa-ken 244 (JP)
Inventor : Morioka, Yoshifumi
11-255 Goizuka-cho
Seto-shi, Aichi-ken 489 (JP)
Inventor : The other inventors have agreed to waive their entitlement to designation.

(74) Representative : Patentanwälte Beetz - Timpe - Siegfried Schmitt-Fumian - Mayr
Steinsdorfstrasse 10
D-80538 München (DE)

## Description

### BACKGROUND OF THE INVENTION

This invention relates to a method for inspecting a solder joint for use with X-ray fluoroscopic imaging apparatus and such an apparatus according to the precharacterizing portions of patent claims 1 and 16 are known from "Proceedings of the Society of Photooptical Instrumentation Engineers", vol. 850, 1988, pages 93-110, Redondo Beach, Ca., USA; R.A. Kuntz et al.: "Automatic SMT inspection with X-ray vision".

With recent trends toward miniaturization and considerable density of printed circuit boards, the surface mounted devices come into wide use. Then the solder joints have become a fine configuration. Soldering inspection by use of an X-ray fluoroscopic image as described in Japanese Patent Application Laid-open Publication No. 219632/1987 (U.S. Application No. 831997); ELECTRONICS/July 15, 1985, pp. 48-52; and ELECTRONIC PACKAGING & PRODUCTION/June 1985, pp. 98-104 has been carried out.

Regarding the wide use of the surface mounted device, the solder joints become a fine configuration as described above, and therefore, locating to a solder joint to be inspected need be done with high accuracy. However, in the aforesaid prior art, the locating to the solder joint is accomplished in dependence of mechanical accuracy from a position obtained by teaching. Therefore, the mechanical accuracy is affected by the accuracy of teaching, the pattern accuracy of a printed circuit board to be inspected, and the mechanical accuracy. It has been difficult to detect a fine solder joint with high accuracy.

In addition, in the aforementioned prior art, no consideration has been given to a dual surface mounted board which came into wide use with the trend of considerable density of a printed circuit board but only one-surface mounted board has been taken into consideration.

Furthermore, the brightness of a transmitted X-ray image of a solder joint corresponds to the thickness of the solder joint. In the prior art, a position of the solder joint cannot be decided with good accuracy for the reason described later, and the brightness only in a specific area within the solder joint is used as a reference value for comparison. Only the thickness of a part of the solder joint is decided. Also, no consideration has been given to the quantity of solder and a cubic shape of fillet.

Moreover, if the X-ray is irradiated on a part for a long period of time, the part is damaged. However, in the prior art, no consideration has been given to reduce the damage.

The article of R.A.Kuntz et al. mentioned above discloses a method for inspecting a solder joint for use with X-ray fluoroscopic imaging apparatus, the method comprising the steps of obtaining an X-ray fluoroscopic image signal by irradiating an X-ray on an object to be inspected which is located by a specimen stage and is formed by soldering a lead of an electronic part to a substrate at said solder joint, extracting a position of said solder joint of said object to be inspected from said obtained X-ray fluoroscopic image signal, defining, from the X-ray fluoroscopic image signal, a plurality of inspection areas on a solder portion and a peripheral portion of the solder joint in accordance with the extracted position of said solder joint. Further this article describes an apparatus for inspecting a solder joint using X-ray fluoroscopic imaging, the apparatus comprising means for irradiating an X-ray generated from an X-ray source; a specimen stage for locating an object to be inspected having a lead of an electronic part soldered to a substrate; an X-ray detector for detecting an X-ray fluoroscopic image obtained by transmitting said X-ray through solder joints of the object located by said specimen stage; solder-joint position extracting means for extracting a position of each of the solder joints of said object to be inspected in accordance with said X-ray fluoroscopic image signal detected by said X-ray detector; inspection-area setting means for setting a plurality of inspection areas on each of i) a portion of a solder joint and ii) a peripheral portion of a solder joint, corresponding to each of the solder joints in accordance with the extracted position of each solder joint extracted by said solder joint position extracting means.

### SUMMARY OF THE INVENTION

It is an object of the present invention to provide a method and apparatus for inspecting a solder joint by an X-ray fluoroscopic image in which in correspondence to a finer solder joint, the solder joint is automatically detected from a detection image signal, and on the basis of the result therefrom, the quantity of solder and the shape of fillet can be detected every solder joint to decide a defect.

It is a further object of the present invention to provide a method and apparatus for inspecting a solder joint by an X-ray fluoroscopic image in which the defect decision can be made with respect to a dual surface mounted board similarly to one surface mounted board.

It is another object of the present invention to provide a method and an apparatus for inspecting a solder joint by an X-ray fluoroscopic image in which a damage of a part caused by the X-ray can be reduced, without deteriorating the inspection performance, to decide a defect of the solder joint.

It is still another object of the present invention to provide a method and apparatus for inspecting a solder joint by an X-ray fluoroscopic image in which a defect decision with good accuracy can be made with respect to a fine soldering bridge or a soldering ball produced between leads while removing an influence of a lead frame (hereinafter referred to as lead) image on a board on which a J lead part or the like is mounted or J lead parts.

It is another object of the present invention to provide a method and apparatus for inspecting a solder joint by an X-ray fluoroscopic image which can inspect and decide a deviation in mounted position of an IC lead on a circuit board, a bend of lead and the like.

These objects are accomplished with a method and an apparatus as claimed in claims 1 and 16, respectively.

Dependent claims are directed on features of preferred embodiments of the invention.

Paying attention to the fact that a portion between IC leads is divided into a plurality of decision areas according to the presence or absence or kind of a lead image of IC, and in an area where no lead image is present, an image of a solder bridge is obtained at a darker level than a material of a printed circuit board, according to the present invention, a threshold which separates from the material portion to actualize only the solder bridge is used to form a binary image and decide the presence or absence of the solder bridge. On the other hand, in an area in which a plate-like lead image is detected, paying attention to the fact that a solder image is detected at a darker level than the lead image, a threshold which actualizes a level below a lead frame image is used to form a binary image, and the presence or absence of a soldering bridge or a soldering ball is decided. Furthermore, in an area in which a wiring pattern of a lead is detected, a threshold which separates from a material portion of a printed board, and a soldering image as well as a lead are simultaneously actualized is used to form a binary image, and the number of patterns is obtained from the signal of the binary image. Then, decision of coincidence and non-coincidence with respect to the number of good reference patterns obtained in advance in a similar manner is effected. Thereby, even if a fine soldering bridge or a soldering ball having a smaller contrast than a lead image is mixed with a lead image, decision can be made in the form of non-coincidence with the number of patterns, thus enabling an inspection with high sensitivity.

By employment of such an inspection method as described above, it is possible to detect and decide with high sensitivity a fine solder having a thickness less than a lead from an image in which a soldering image such as a bridge is superimposed to a lead image of IC and detected, enabling to obtain a high detection performance.

Moreover, paying attention to a partial image of a pad of a solder joint detected as a relatively dark shade image in an area externally of a tip portion of an IC lead image on the X-ray image, according to the present invention, a distribution of image projection (addition) in that area is obtained, and a pad position of the solder joint is detected from said distribution. And a decision area is provided between the pads on the X-ray image on the basis of a result of detected position of the pad, and evaluation of a binary image with respect to the IC lead image forced into the decision area is effected, on the basis of which a decision of deviation in position of the IC lead is effected.

As an alternative method in connection with the setting of an area for deciding a deviation of the lead, a reference position recognition pattern is provided in advance on an inspection circuit board, and a decision area is set between pads of a solder joint on the basis of the result of recognition of a position of the X-ray image with respect to said pattern. Or, this recognition of a reference position is effected paying attention to a clearance pattern or the like detected as a high contrast pattern on the X-ray image of a circuit board to achieve the aforesaid object.

By employment of the above-described inspection method, the quantitative detection of a deviation amount of an IC lead with respect to a solder pad on the circuit board becomes possible. It also becomes possible to decide a deviation in position of lead and a bend of lead with high accuracy.

## BRIEF DESCRIPTION OF THE DRAWINGS

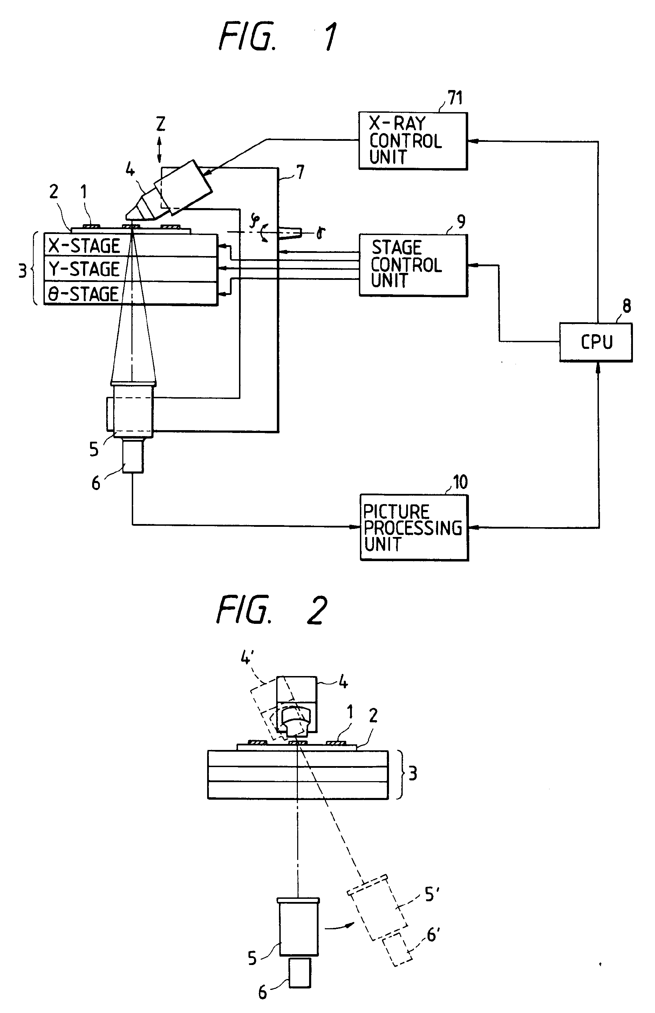

Fig. 1 is a schematic structural view showing one embodiment of apparatus for inspecting a solder joint by detected from said distribution. And a decision area is provided between the pads on the X-ray image on the basis of a result of detected position of the pad, and evaluation of a binary image with respect to the IC lead image forced into the decision area is effected, on the basis of which a decision of deviation in position of the IC lead is effected.

As an alternative method in connection with the setting of an area for deciding a deviation of the lead, a reference position recognition pattern is provided in advance on an inspection circuit board, and a decision area is set between pads of a solder joint on the basis of the result of recognition of a position of the X-ray image with respect to said pattern. Or, this recognition of a reference position is effected paying attention to a clearance pattern or the like detected as a high contrast pattern on the X-ray image of a circuit board to achieve the aforesaid object.

By employment of the above-described inspection method, the quantitative detection of a deviation amount of an IC lead with respect to a solder pad on the circuit board becomes possible. It also becomes possible to decide a deviation in position of lead and a bend of lead with high accuracy.

## BRIEF DESCRIPTION OF THE DRAWINGS

FIG. 1 is a schematic structural view showing one embodiment of apparatus for inspecting a solder joint by an X-ray fluoroscopic image;

FIG. 2 is a side view showing one embodiment in which the X-ray is obliquely irradiated on the substrate with IC or the like mounted thereon to detect an X-ray fluoroscopic image;

FIG. 3 is a view showing the form of an IC mounted on the substrate;

FIG. 4 is a partial side view showing the state in which various ICs are bonded by solder;

FIG. 5 is a view showing various defects in the solder joint.

FIG. 6 is a view showing the transmitted X-ray dosage in case of J lead;

FIGS. 7a, 7b and 7c illustrate the detection of a fillet shape in case of J lead;

FIG. 8 is a structural view specifically showing a picture processing unit shown in FIG. 1;

FIG. 9 is a view showing the structure of a device for normalizing a detecting image;

FIG. 10 is a view showing an area projected toward a normalized imge f (i, j);

FIG. 11 is a view showing a schematic structure of one example of a J lead solder joint;

FIGS. 12a and 12b are views showing the state in which the X-ray is irradiated on the J lead solder joint shown in FIG. 11, and the X-ray fluoroscopic image obtained by a camera;

FIGS. 13a and 13b are views showing a section of a J lead solder joint in the lead tip direction, and the brightness of the X-ray fluoroscopic image;

FIGS. 14a and 14b are views showing an area projected in a horizontal direction and a distribution H(j) of horizontal projection;

FIG. 15 illustrates the detection of positions (js ~ je) of a vertical solder joint with a threshold Thl with respect to the distribution H(j) of horizontal projection;

FIGS. 16a and 16b are views showing an area projected in a vertical direction and a distribution V(i) of vertical projection;

FIG. 17 illustrates the detection of positions ($i_{sn}$ ~ $i_{en}$) of a horizontal solder joint with a threshold Th2 with respect to the distribution V(i) of vertical projection;

FIG. 18 is a view showing an example of a sectional shape of a defect of deviation in lead and its X-ray fluoroscopic image;

FIG. 19 is a view showing an example of a defect of a lifted lead;

FIGS. 20a and 20b are views showing the relationship between a center position of a solder joint obtained by a good solder joint and a center position of a lead obtained with no soldering joint;

FIGS. $21a_1$ to $21c_4$ are views showing a fillet shape in the case where in J lead, solder is short, and a fillet shape in the case where in J lead, there is normal solder, respectively;

FIG. 22 is a view showing a typical good fillet waveform obtained by clustering a number of good fillet waveforms;

FIG. 23 is a view showing a flow for setting a reference good image;

FIG. 24 is a view showing an X-ray fluoroscopic binary image when a soldering ball and a soldering bridge are present, a distribution of projection thereof, and a waveform with said distribution of projection binarized by a threshold Th3;

FIG. 25 is a view showing the form in which a printed board is inclined in a lead row direction to detect an X-ray fluoroscopic image;

FIG. 26 is a view showing an X-ray fluoroscopic image detected by removing an overlap of a solder joint in the form shown in FIG. 25;

FIG. 27 is a view showing the X-ray fluoroscopic image shown in FIG. 26 in an enlarged scale and a distribution of vertical projection in the lead tip direction;

FIG. 28 is a view showing a flow of image processing when the substrate is not tilted;

FIG. 29 is a view showing a flow of image processing when the substrate is tilted;

FIG. 30 is a view showing an inspection flow of a dual mounted substrate;

FIG. 31 is a plan view and a -front view showing clockwise faces $F_1$ - $F_4$ of IC to be inspected;

FIGS. 32 and 33 are respectively views of an image intensifier and the case where a TV camera is moved to detect an X-ray floroscopic image with respect to a dual mounted substrate;

FIG. 34 is a view showing the case where a shutter is provided so as not to irradiate the X-ray on only the IC for which X-ray fluoroscopic image is detected in the solder joint;

FIG. 35 is a view showing an example of an X-ray fluoroscopic image with respect to a solder joint having a defect of a soldering bridge or solding ball and a lead;

FIG. 36 is a view showing the case where areas (A) to (C) are set to a solder joint having a defect of a soldering bridge and a lead;

FIG. 37 is a viw showing an X-ray fluoroscopic image on a scanning line shown in FIG. 36;

FIG. 38 is a view showing an image signal with only the bridge actualized in the areas (A) to (C);

FIGS. 39a to 39c are views for explaining a method for deciding a bridge in the area (A);

FIGS. 40a to 40c are views for explaining a method for deciding a bridge in the area (B);

FIG. 41 is a view showing the case where two kinds of binary images are prepared by use of two thresholds with respect to the area (B) where a pattern image of a lead is detected;

FIGS. 42a to 42d are views -for explaining a method for deciding a bridge from a binary image signal caused by a threshold Vh;

FIGS. 43a to 43d are views for explaining a method for deciding a bridge from a binary image signal caused by a threshold $V\ell$;

FIG. 44 is a view showing a dual mounted substrate to which a bridge decision can be applied;

FIG. 45 is a view showing an X-ray fluoroscopic image obtained from a dual mounted substrate having a bridge defect;

FIG. 46 is a view showing the case where three thresholds Vh, Vm and Ve are provided in the area (B) in the image shown in FIG. 45 to obtain three kinds of binary image signals;

FIGS. 47a - 47d, 48a - 48d and 49a - 49d are respectively views illustrating a method for deciding a bridge from each of three binary image signals;

FIGS. 50a - 50C are views showing normal and lead-deviated X-ray fluoroscopic images, respectively, in the J lead;

FIGS. 51a and 51b are views illustrating a method for obtaining a distribution H(j) of horizontal projection with respect to X-ray fluoroscopic images of the J lead shown in FIGS. 50a - 50C;

FIG. 52 is a view showing the detection of positions (js, je) of a vertical solder joint from the distribution H(j) of horizontal projection;

FIGS. 53a and 53b are views showing areas jp1 - jp2 moved through a predetermined amount with respect to the js and je shown in FIG. 52 and a distribution V(i) of vertical projection in said areas;

FIG. 54 is a view showing a method for obtaining decision areas ($i_{sn}$ - $i_{en}$) by thresholding the distribution V(i) of vertical projection wiith the threshold Th2;

FIGS. 55a - 55c are views for explaining a method for deciding a lead-deviated defect with respect to the decision areas ($i_{sn}$ - $i_{en}$);

FIG. 56 is a view showing another embodiment for obtaining a lead-deviation decision area set between substrate pads;

FIG. 57 is a view for obtaining distributions Hm(j) Vm(i) of projection in a horizontal direction and in a vertical direction with respect with position recognition reference patterns shown in FIG. 56; and

FIG. 58 is a front view showing a dual mounted substrate in which ICs are arranged on both surfaces thereof with a pitch P deviated by P/2 so that X-ray fluoroscopic images such as leads in both surfaces are not overlapped.

## DESCRIPTION OF THE PREFERRED EMBODIMENTS

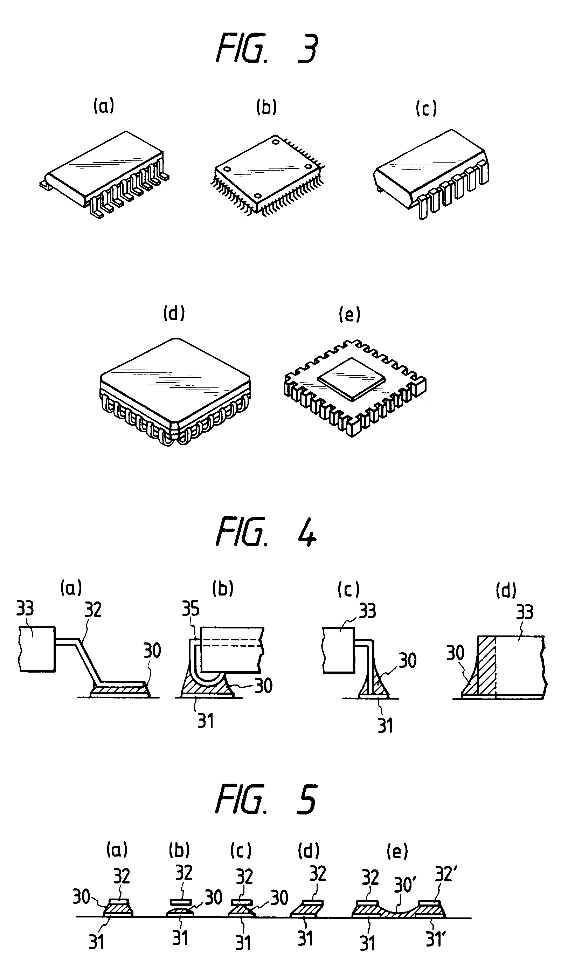

One embodiment of the present invention will be described hereinafter with reference to FIG. 1. In FIG. 1, a printed circuit board (PCB) 2 with a part 1 mounted by soldering is placed on a XYθ stage composed of X, Y and θ stages. A micro-focusx-ray source 4, an image intensifier 5 as an X-ray image detector and a TV camera 6 are mounted on a φ stage 7 which rotates about r in a direction of φ. As shown in FIG. 2, the X-ray is obliquely irradiated on the PCB 2 so that a transmitted X-ray image can be detected. An X-ray control unit 71 controls voltage of the X-ray source 4, current thereof, focussing, generation of X-ray, etc. according to a command of a CPU 8. The X-ray source 4 can be controlled in a direction of z. A stage control unit 9 actuates the XYθ stage 3 and the φ stage 7 according to a command of the CPU 8. A picture processing unit 10 receives a video signal from the TV camera 6, and processes an image according to a command of the CPU 8. As the result, the CPU 8 decides a defect of each solder joint.

FIG. 3 shows typical examples of surface mounted parts which comprise main objects in the present invention. That is, FIG. 3(a) shows Gull Wing lead type (abridged as SOP), FIG. 3(b) Quad Flat Package type (QFP), FIG. 3(c) Mini Square Package type (MSP) with Butt-joint lead, FIG. 3(d) Plastic Leadless Chip Carrier type (PLCC) with J-lead, and FIG. 3(e) Leadless Chip type which is a lead-less type.

FIG. 4 shows a section of a solder joint of the above-described type. FIG. 4(a) shows (SOP) or (QFP) type, FIG. 4(b) (PLCC), FIG. 4(c) (MSP), and FIG. 4(d) (LCC). In FIG. 4, reference numeral 30 designates a solder, 31 a substrate pad, 32 a lead, 33 a package, and 35 a J lead. The lead will be generally referred to as "lead 32" except the special case, including the J lead.

In the present invention, in order to explain how the X-ray imge of the solder joint is processed and how a defect is decided, an example of J lead called PLCC (Plastic Leaded Chip Carrier) and SOJ (Small Outline J-bend) will be described hereinafter. As shown in FIG. 4(b), in the J lead, the solder joint is hidden under the part, and it is difficult to externally decide a defect. This is one of parts desired to be inspected in solder by the X-ray.

FIG. 5 shows examples of defects to be inspected.

How defects involved when the amount of solder is improper such as a short of solde, a surplus of solder, etc. represented by the case of a small fillet as shown in FIG. 5(c), and other lifted lead, deviated lead, bridge, etc. are detected will be described hereinafter. In FIG. 5, FIG. 5(a) shows the case of a good product, in which 30 is a solder, 31 a substrade pad and 32 a lead. FIG. 5(b) shows the case where the lead 32 is apart (lifted) from the solder 30. FIG. 5(c) shows the case where a fillet is small. FIG. 5 (d) shows the case where a lead 35 is considerably deviated from the substrate pad 31. FIG. 5(e) shows the case where leads 32 and 32' adjacent to each other form a bridge by a solder 30'.

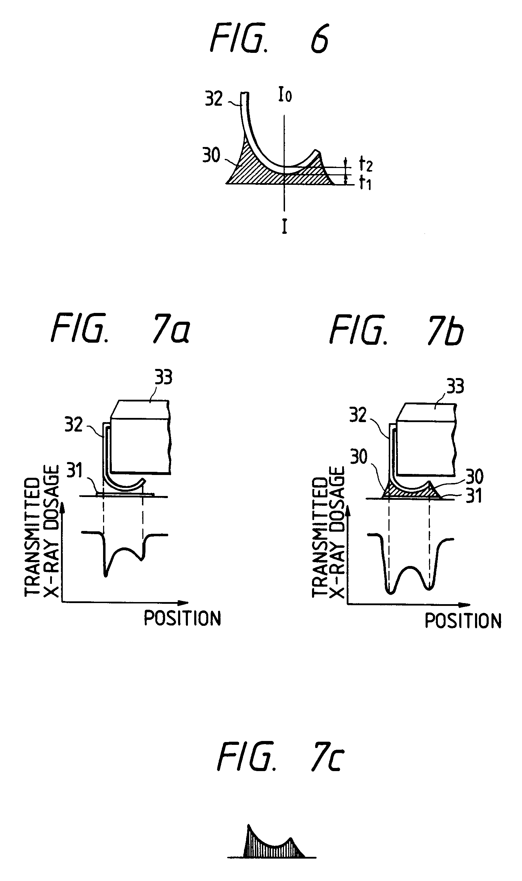

FIG. 6 is a view for explaining formation of a transmitted X-ray image in J lead. Let $I_o$ be the intensity of incident X-ray, $t_1$ be the thickness of a solder joint, $t_2$ be the thickness of those other than the solder, for example, the thickness of lead, $\mu_1$ be the X-ray absorption coefficient of solder, and $\mu_2$ be the X-ray absorption coefficient of those (mainly, lead and wiring pattern) other than solder, then the transmitted X-ray image is given by

$$I = I_o \exp(-\mu_1 t_1 - \mu_2 t_2) \quad (1)$$

The X-ray absorption coefficient is a constant determined by a material and a wavelength of X-ray, which is large as the atomic number increases (absorbs much X-rays). Since the solder joints (Pc and Sn) are larger than other portions (Fe, Cu, etc.), they become dark. If Equation (1) is subjected to logarithmic conversion, then Equation (2) below is obtained:

$$\ell n I = \ell n I_o - \mu_1 t_1 - \mu_2 t_2 \quad (2)$$

and the image after the logarithmic conversion remains unchanged.

If Equation (2) is further modified, then Equation (3) below is obtained:

$$t_1 = \frac{\ell n I_o - \ell n I - \mu_2 t_2}{\mu_1} \quad (3)$$

$I_o$ and $\mu_1$ are constant. $\mu_2$ and $t_2$ change in value according to the difference in a wiring pattern of a printed circuit board. However, it is a value mostly determined according to a part and a position of a solder joint since the thickness of the wiring pattern is small, scores of Um. If $\ell n I$ is integrated at the solder joint, the value $(\Sigma t_1)$ obtained by integrating $t_1$, that is, the value corresponding to the amount of solder can be calculated. In this case,

$$\Sigma t_1 = -\frac{\Sigma \ell_n(I/I_o) + \mu_2 \Sigma t_2}{\mu_1} \quad (4)$$

When the lead is deviated, the width of the solder joint becomes widened. Thereby, a deviated lead can be extracted by deciding the width of the solder joint.

Since the solder is darker than the other portions, it can be extracted as a binary image by binarizing it with a suitable threshold. Thereby, the binary image is projected in the lead tip direction between the solder joints whereby defects such as a bridge, a soldering ball, etc. can be extracted.

The X-ray fluoroscopic image when solder is not present is obtained by use of Equation (2) as follows:

$$\ell n I' = \ell n I_o - \mu_2 t_2 \quad (5)$$

From (2) - (5),

$$t_1 = \frac{(\ell n I' - \ell n I)}{\mu_1} \quad (6)$$

That is, a difference of an image between the case where "solder is present" as shown in FIG. 7a and the case where "solder is absent" as shown in FIG. 7b is obtained, whereby a fillet shape as shown in FIG. 7c can be extracted as a distribution of the solder thickness $t_1$. Accordingly, in the aforementioned decision of the amount of -solder, the lifted lead as in "the lead is lifted despite the fact that the amount of solder is normal" can be detected.

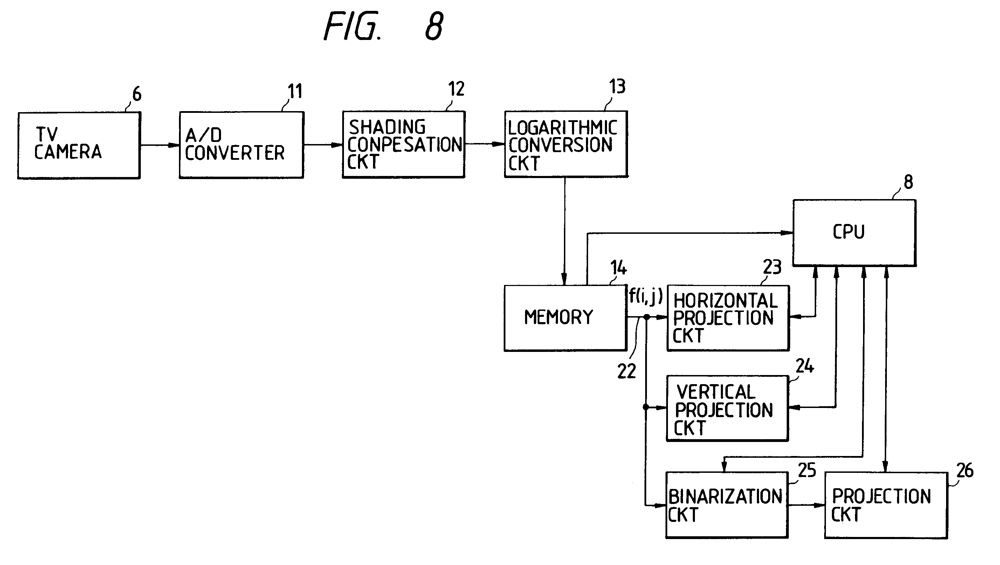

A specific structural example of the picture processing unit 10 (shown in FIG. 1) for effecting the processing as described above is shown in FIG. 8. In FIG. 8, a video signal from a TV camera 6 is converted into a digital value by an A/D converter 11, after which it is inputted into a memory 14 through a shading compensation circuit 12 and a logarithmic conversion circuit 13. The shading compensation is to compensate a variation in video level despite the same brightness in the central portion and in the circumferential portion of a picture plane. Detecting images (called white images) W (i, j) when a material to be inspected is not present and detecting images (called black images) B (i, j) when the X-ray is not generated are used to obtain

$$f (i, j) = \frac{g (i, j) - B (i, j)}{W (i, j) - B (i, j)} \quad (7)$$

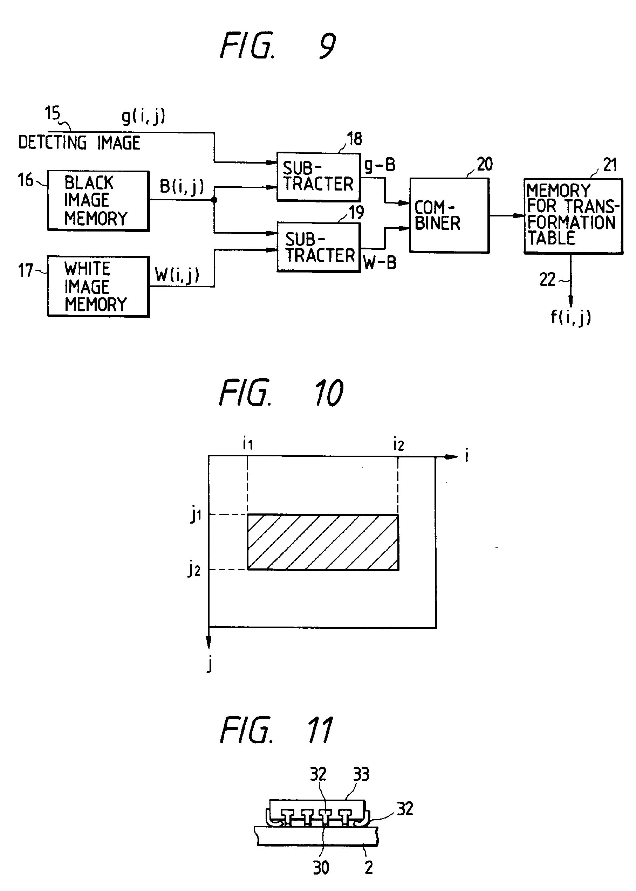

by detecting images g (i, j). Then, the detected image is normalized with respect to the white image and black image. A specific structural example is shown in FIG. 9. In the FIG. 9, the logarithmic conversion is included, and the image after logarithmic conversion is outputted as 1 f(i, j). In FIG. 9, a difference between a detection image signal 15, an output of a black image memory 16, an output of a white image memory 17 and an output of a black image memory 16 is obtained by subtracters 18 and 19. Outputs are combined (g-B)(W-B) as a bit string by a combiner 20. The output of 20 is addressed to read the content of a memory 21 for transformation table 21 to output the image f(i, j) (hereinafter referred to as 22) after transformation. The content of the memory 21 for transformation table is stored upon logarithmic conversion in an address in which a value of the left side of Equation (7) is determined by a denominator and a numerator of the right side thereof.

In FIG. 8, in a horizontal projection circuit 23 and a vertical projection circuit 24, the horizontal projection H(j) and the vertical projection V(i) are obtained as below with respect to the image 22 (wherein an area projected designated by CPU 8 is an area as indicated by hatching in FIG. 10):

$$H(j) = \sum_{i=i_1}^{i_2} f (i, j)$$

$$V(i) = \sum_{j=j_1}^{j_2} f(i, j)$$

A binarization circuit 25 is designed so that a threshold (a solder or lead portion is detected as an X-ray image to be darker than other portions) for actualizing a solder (such as a bridge) or lead present between solder joints is designated by the CPU 8 to binarize the image stored in the memory 14. A projection circuit 26 prepares a projection in the lead tip direction with respect to the binary image in an area designated by the CPU 8.

The sequence of the inspection in this embodiment will be described. The CPU 8 controls the stages 3 and 7 (shown in FIG. 1), locates a printed circuit board and inputs an X-ray fluoroscopic image into the memory 14 in accordance with positional inforamtion of the solder joint obtained from teaching or design information. Subsequently, the CPU 8 designates projection areas with respect to the horizontal and vertical projection circuits 23 and 24 to prepare projections, analyze projections and detect the position of the solder joint. The CPU 8 analyzes the projections obtained by the 23 and 24 and the image inputted into the memory 14 in accordance with the positon of the detected solder joint to extract a defect of each solder joint. The projection of the binary image is obtained by the projection circuit 26, and a defect between the solder joints is extracted by how the obtained projection is analyzed.

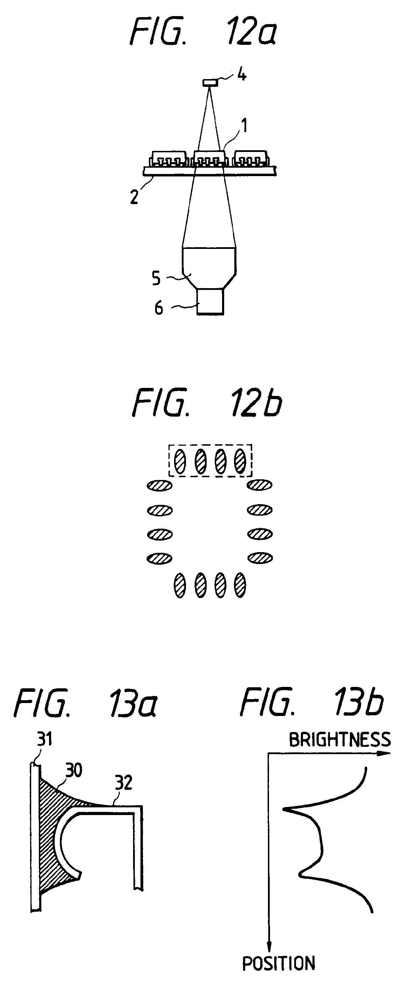

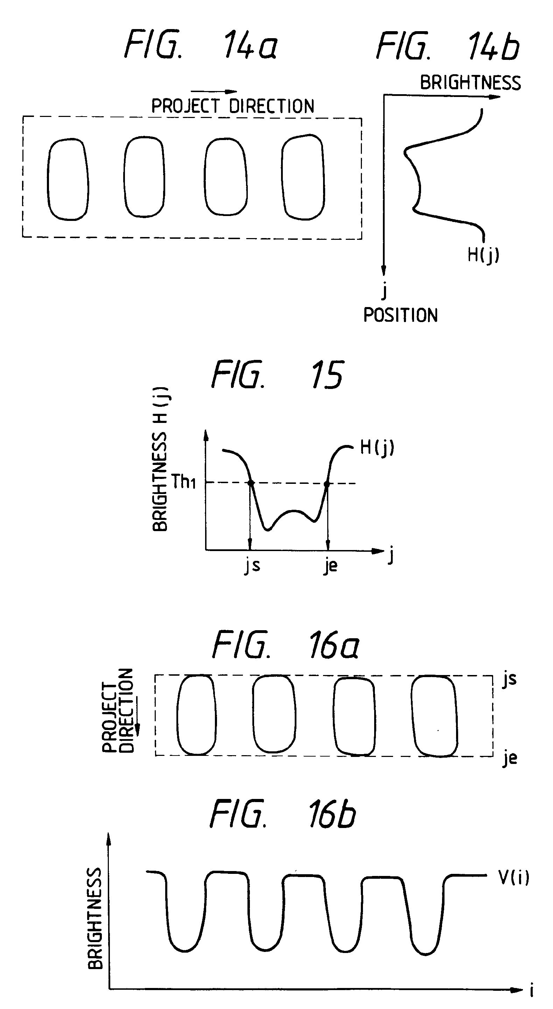

The aforementioned operation will be explained by way of an inspection of a solder joint of J lead called PLCC (Plastic Leaded Chip Carrier) as shown in FIG. 11. As shown in FIG. 12a, when the X-ray is irradiated, an X-ray fluoroscopic image as shown in FIG. 12b is obtained. In the following description, solder joints surrounded by the broken lines in FIG. 12b are arranged as an example. FIG. 13a shows a section of a solder joint of J lead, and FIG. 13b shows a variation in brightness of X-ray image in the lead tip direction. The brightness of the X-ray image becomes dark as the solder thickness increases. In FIG. 13b, the X-ray image becomes darkest at a raised portion of the J lead. However, since the lead is smaller in absorption of X-ray than the solder, the X-ray image is darker than that of a portion where the solder thickness is maximum. When a horizontal projection is obtained by the horizontal projection circuit 23 in an area as shown in FIG. 14a with respect to the X-ray fluoroscopic image of the J lead having the feature as mentioned above, the distribution H(j) of a brightness addition value of horizontal projection as shown in FIG. 14b is obtained. The CPU 8 receives the H(j) and obtains points of intersection js and je between the threshold Thl and the brightness addition value H(j) as shown in FIG. 15 to set positions of the vertical solder joints. Here, the threshold Thl is set in advance, or a value is used which is subjected to interior division with a ratio wherein the maximum and mininum values of the inputted horizontal projection H(j) are set in advance.

Next, when the vertical projection circuit 24 is used in the area surrounded by the dotted lines as shown in FIG. 16a with the vertical projection range being Js to je to obtain the vertical projection V(i), the distribution of brightness (addition value) as shown in FIG. 16b is obtained. The CPU 8 shown in FIG. 8 inputs the vertical projection V(i) to obtain the threshold $Th_2$ and points of intersections $is_1$, $ie_1$ to $ie_4$, $is_4$ of V(i) to serve as the solder joint in the horizontal direction i. The threshold $Th_2$ is set similarly to the $Th_1$.

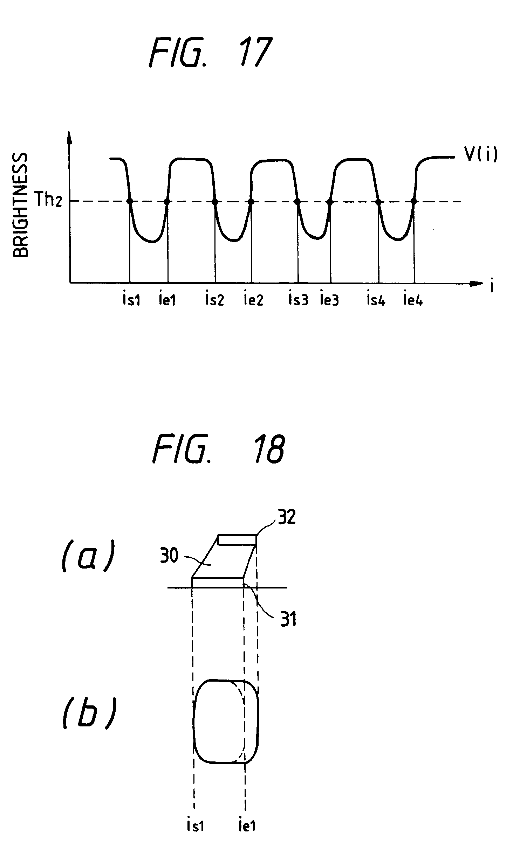

(a) of FIG. 18 shows an example of a sectional shape of a deviated lead, and (b) thereof is a plan view showing a solder joint obtained by an X-ray fluoroscopic image. As will be apparent also from FIG. 10, $i_{sn} \sim i_{en}$ (n = 1 $\sim$ 4) obtained in FIG. 17 -are compared with good solder joint to thereby detect a deviated lead.

As previously mentioned, the X-ray fluoroscopic image has a brightness corresponding to the thickness of material. Thereby, one to which image value is added corresponds to the amount of solder in the solder joint. In sections $(is_n, i_{en})$ (n = 1 $\sim$ 4), if V(i) is integrated, a value corresponding to the amount of solder which corresponds to each solder joint can be obtained. This can be compared with a good one to thereby extract a surplus or short of solder.

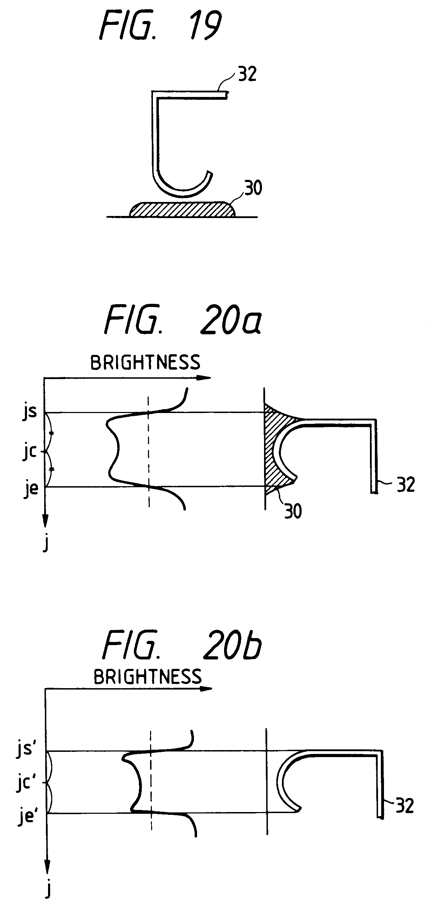

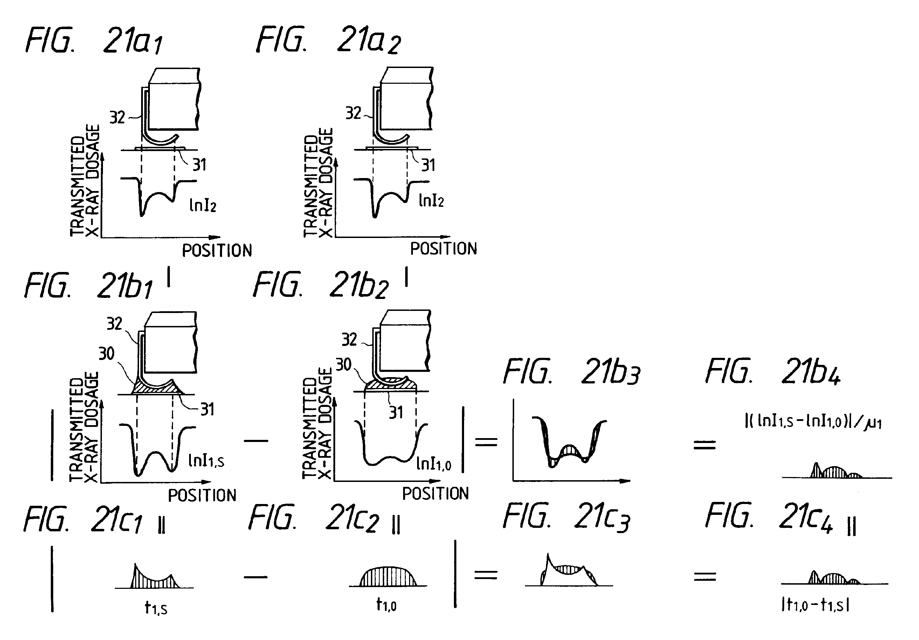

FIG. 19 shows an example of a lifted lead in which the amount of solder is normal but lead is lifted. In the present invention, a fillet shape is decided to detect such a defect. In order to extract a fillet shape, the horizontal and vertical projection circuits 23 and 24 shown in FIG. 8 are used with respect to the X-ray image when solder is not present to detect a solder joint. Since the lead portion has no solder but the lead thickness is thicker than other portions and is Fe or Cu, it has a darker image value than other portions. Therefore, as far as the lead row (arrangement) direction is concerned, substantially the same position as the good product is detected. Also with respect to the lead tip direction, as shown in FIG. 20a and 20b, a middle point jc (FIG. 20a) between positions js and je obtained in a good product and a middle point jc' (FIG. 20b) between positions js' and je' assume substantially the same postion with respect to the lead. That is, if in the lead tip direction, positioning is adjusted so that jc and jc' are coincided, the lead when solder is not present can be adjusted in position to the image of an object to be inspected. An image data is inputted in advance from the memory 14 to the CPU 8 from the image without solder with jc' used as a reference at the center (position of (isk + iek)/2) in the position of the lead row direction in each solder joint. Then, a similar image data is inputted from the CPU 8 to the memory 14 in each solder joint from the image of an object to be inspected to obtain a difference from the image data without solder, whereby the fillet shape is extracted as in FIG. 21. A defect is decided by the fillet shape when a difference between a good fillet shape and a fillet shape of an object to be inspected exceeds a set value.

The decision of fillet shape will be described with reference to FIGS. $21a_1$ to $21c_4$.

Systems of FIG. $21a_1$, FIG. $21b_1$ and FIG. $21c_1$ are similar to those of FIG. 7a to FIG. 7c as previously mentioned. In this case, if a difference between an image pattern of non-soldering shown in FIG. $21a_1$ and an image pattern of having soldering shown in FIG. $21b_1$ is obtained, a fillet shape shown in FIG. $21c_1$ is extracted as a distribution of the solder thickness $t_{1, s}$. This system is provided with one having a fillet having a good solder joint, that is, "good fillet shape".

Next, when a solder joint of an object to be inspected subjected to decision of a fillet shape is similarly processed, a fillet shape provided with a distribution of solder thickness $t_{1, o}$ is finally obtained as shown in FIG. $21a_2$, FIG. $21b_2$ and FIG. $21c_2$.

Then, if a difference between a shape $(t_{1, s})$ shown in FIG. $21c_1$ and a shape $(t_{1, o})$ shown in FIG. $21c_2$ is obtained, a shape of difference $|t_{1,o} - t_{1, s}|$ shown in FIG. $21c_4$ is finally obtained as shown in FIG. $21c_3$. A decision of a fillet shape can be made on the basis of said result.

An embodiment of a simplified deciding method will be further described.

When a difference between a pattern having a solder joint with a good fillet shape as shown in FIG. $21b_1$ and a pattern having a solder joint of an object to be inspected shown in FIG. $21b_2$ is obtained, it results as shown in FIG. $21b_3$. The thus obtained pattern is similar in shape to that shown in FIG. $21c_4$. In this case, it is not at all necessary to compare them one by one with that of non-soldering, and therefore, the decision of a fillet shape is materially simplified, in which respect, inspection means having an outstanding effect is obtained.

In the aforementioned figures, the symbols used are as follows:

The solder thickness of a solder joint as an object to be inspected: $t_{1,o}$ is given by

$$t_{1,o} = (\ell nI_2 - \ell nI_{1,o}) / \mu_1$$

The solder thickness of a good solder joint: $t_{1,s}$ is given by:

$$t_{1,s} = (\ell nI_2 - \ell nI_{1, s}) / \mu_1$$

Accordingly, in this case,

$$|t_{1,o} - t_{1,s}| = 1(\ell nI_{1,s} - \ell nI_{1,o})| / \mu_1$$

where

$I_2$: Transmitted X-ray dosage of lead

$I_{1,o}$: Transmitted X-ray dosage of solder joint as an object to be inspected

$I_{1,s}$: Transmitted X-ray dosage of a good solder joint

$\mu_1$: X-ray absorption coefficient of solder

The above description can be replaced by the following description (This is substantially similar to the former but will be described for a better understanding since this comprises an important point.)

In the decision of a fillet shape, a different between it and a good fillet waveform is obtained.

$$\Sigma \mid F - F_o \mid = \Sigma \mid \bar{f} - f - (\bar{f} - f_o) \mid$$
$$= \Sigma \mid f - f_o \mid \quad (8)$$

where F : fillet shape to be inspected, f : detection waveform, $F_o$ : good fillet waveform, $f_o$ : good detection waveform, $\bar{f}$ : waveform of non-soldering Therefore, the decision can be accomplished without using an image of non-soldering.

Even the soldering state is the same, there are a variety of good products due to unevenness of a supply of solder, a slight deviation of lead and the like. There are also a variety of shapes of waveform signals in the X-ray image. It is therefore effective that a plurality of good waveforms corresponding to a variation of soldering, a good waveform by which the value of Equation (8) is minimum is obtained, and the quality is decided from that value. The problem is how the good waveform is prepared corresponding to the variation. In the present invention, a number of good waveforms are collected, fillet waveforms $GW_1$ to $GW_M$ of a number of good products are subjected to clustering, those similar in shape are collected, the whole good waveform is divided into a few classes, and a typical good waveform is automatically extracted every class. The algorithm of clustering includes a so-called K average algorithm. A system for automatically extracting a good waveform by use of the aforesaid algorithm is described below.

In the figure, $WM_1$ - $WM_R$ designate means for average of waveform, $S_1$ - $S_N$ reference waveforms for decision, W a detection fillet shape obtained by the reference waveforms $S_1$ - $S_N$, and min $\mid W - Sj \mid \geqq \varepsilon$ (j = 1 to N) defect decision condition with $\varepsilon$ as the decision threshold, respectively.

K average algorithm: n number of good waveforms are divided into K classes. The following steps are carried out.

Step 1: Zj(1) (j=1, 2, ...k) is used as the center of K number of initial clusters, K number is suitably selected from good waveforms $X_1$ (i=1, 2, ... n).

Step 2: Xi is compared with Zj(k) (k=1,2, ...) to search the most similar Zj(k). n number of good waveforms Xi are divided into K number of classes.

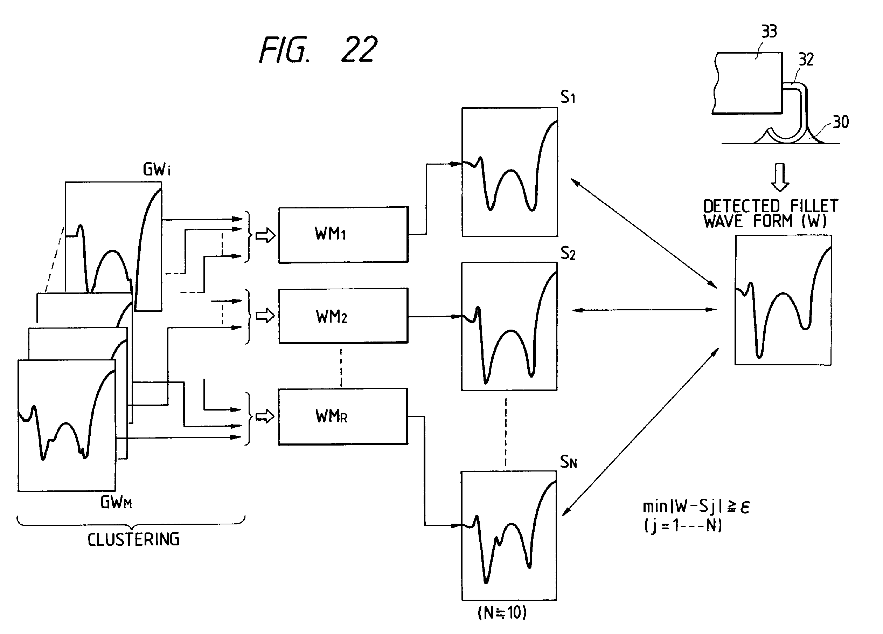

Step 3: The operation of the following equation is effected so that the sum of differences between all Xi belonging to Zj(k) and the cluster center is minimum. The cluster center is changed to Zj(k+1). (The averaging of waveform is effected by $WM_1$ to $WM_R$ shown in FIG. 22.)

$$Zj(k + 1) = (\Sigma Xi) / Nj$$
$$Xi \in Zj (k)$$

where, Nj : number of X1 belonging to Zj(k)

Step 4: With respect to all j, the step is returned to Step 2 till Zj (k+1) = Zj (k) is established. If established, Zj (k) is taken as a good waveform.

The method for selecting good waveforms by use of the K average algorithm has been described. This selection is carried out every part or every specific solder joint to thereby obtain good waveforms ($S_1$ - $S_n$) as a decision reference.

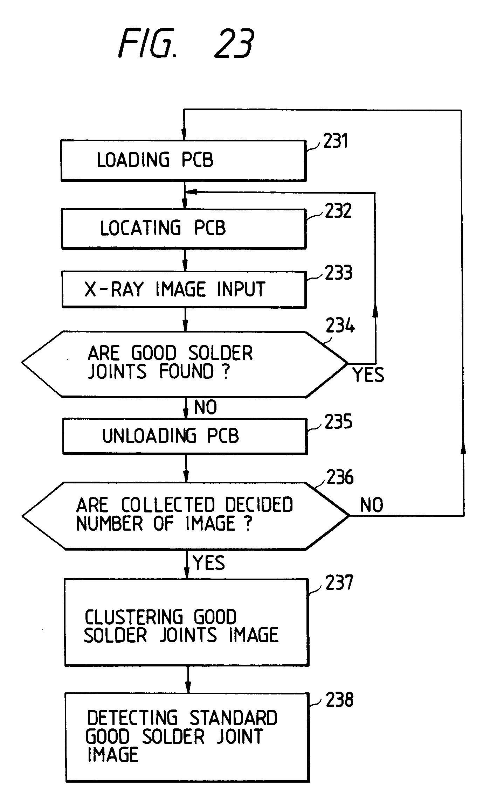

In order to cope with the variation of soldering, it is important to collect good waveforms of not only a single printed board but a number of printed boards. The collection of good waveforms and the selection of reference good waveform are shown by a flow of FIG. 23. As shown in FIG. 23, a position of a solder joint is extracted from the X-ray image similar to the inspection. A waveform signal of the solder joint is inputted into the CPU 8 on the basis of the obtained result. These waveforms are sequentially stored in the memory. After a predetermined number of waveforms have been collected, good waveforms are selected by clustering.

While in the foregoing, data to be collected has been increased with respect to the variation of a number of soldering, it is to be noted that a variation is prepared artificially such that a supply of solder is changed or a part is placed while being deviated, and a detected waveform of the solder joint may be used as a reference.

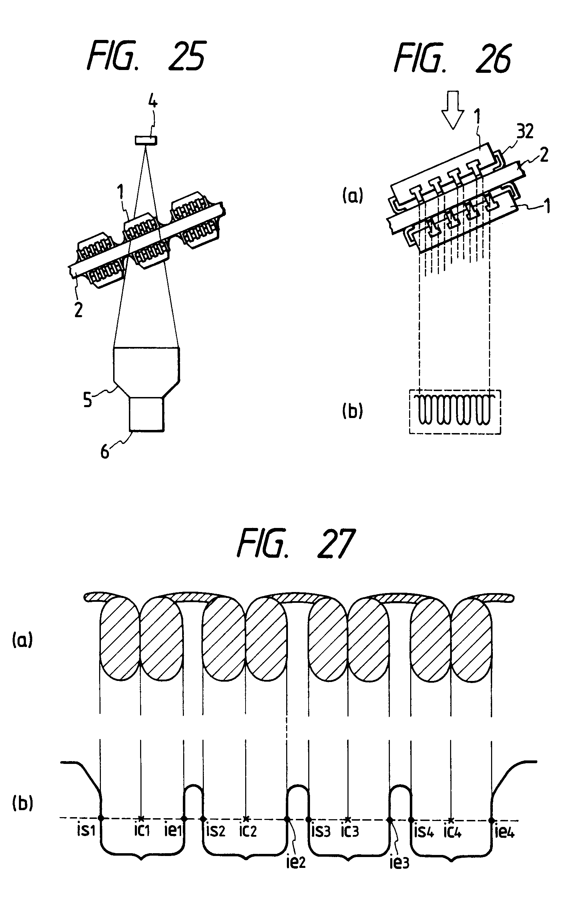

Furthermore, while in the foregoing, the one surface mounted substrate has been used, it is to be noted that an image of a solder joint is detected so that a substrate is tilted as shown in FIG. 25 so that the inside and outside solder joints are not overlapped, whereby similar processing can be made for a dual mounted substrate.

Moreover, while in the foregoing, the fillet decision has been carried out in the lead tip direction, it is to be noted that the decision may be made in the lead row direction on the basis of the position detection of the solder joint.

In addition, instead of comparison with the good fillet waveform, decision can be carried out by analysis of the fillet waveform itself.

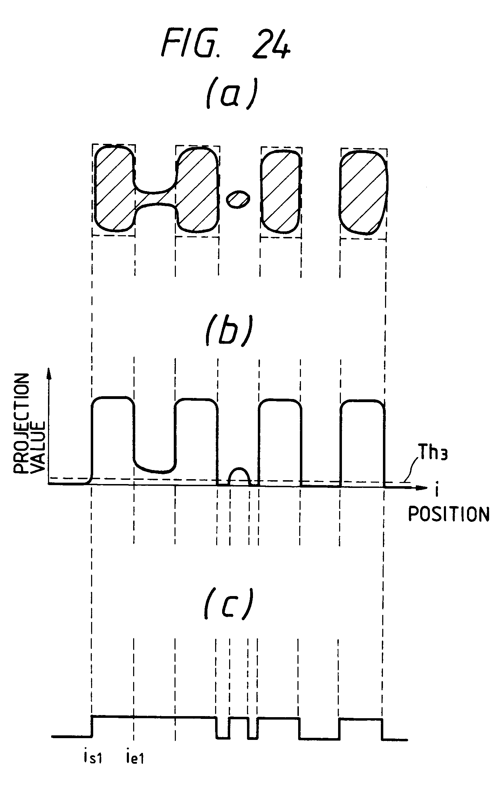

Moreover, defects of solder joint include a bridge, a soldering ball and the like produced between solder joints. In the present invention, a binary image of an X-ray fluoroscopic image is obtained by the binarization circuit 25 shown in FIG. 8, and a binary image is projected in a vertical direction between the solder joints obtained in FIGS. 15 and 17. FIG. 24(a) shows a binary image when a soldering ball and a soldering brige is present, FIG. 24(b) shows a projection, and FIG. 24(c) shows a waveform in which a projection is binarized by threshold Th3. The CPU 8 receives a projection obtained by the projection generating circuit 26, and after the projection has been binarized, the length of "0" from the end between the solder joints is obtained to decide a defect.

As described above, according to the present invention, the horizontal and vertical projection value are obtained with respect to the X-ray fluoroscopic image of the solder joint whereby the position of the individual solder joint is extracted, and defects such as a short of solder, lifted lead, bridge, soldering ball, etc are extracted in accordance with the extracted position. In the future, there is a possibility that the dual mounting as shown in FIG. 25 is often used. In this case, the decision of a deviated lead, bridge and soldering ball may be carried out by the aforementioned system, but there is a possibility that the inside and outside solders are overlapped, the dynamic range of detection is short, and the sensitivity of detection of surplus or short of solder lowers. As shown in FIG. 25, in such a case, the substrate (printed board) is tilted in the lead row direction, and the inside and outside solder joints are deviated to remove an overlap before detection. FIG. 26 shows an example of the thus detected X-ray fluoroscopic image. FIG. 26(a) shows the case where the dual mounted substrate is tilted, and FIG. 26(b) shows the X-ray fluoroscopic image. In the projection (vertical) in the lead tip direction, the FIG. 27 configuration results, and only a set of inside and outside solder joints can be separated in the system shown in FIG. 17. In such a case, a middle point $ic_n$ beteen $is_n$ and $ie_n$ is obtained as shown in FIG. 27 whereby the inside and outside may be separated to evaluate the amount of solder. If the extraction of fillet shape is carried out at each center portion of $is_n$ to $ic_n$ and $ic_n$ to $is_n$, it can be carried out exactly similarly to the one surface mounted substrate.

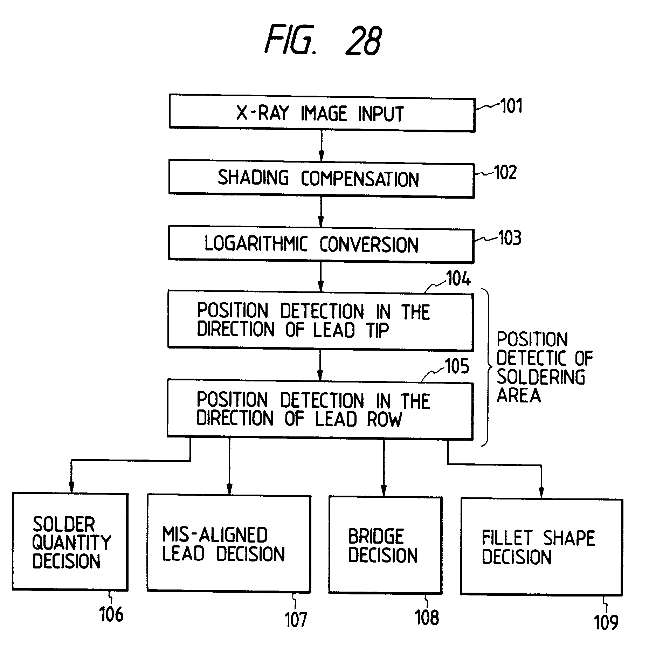

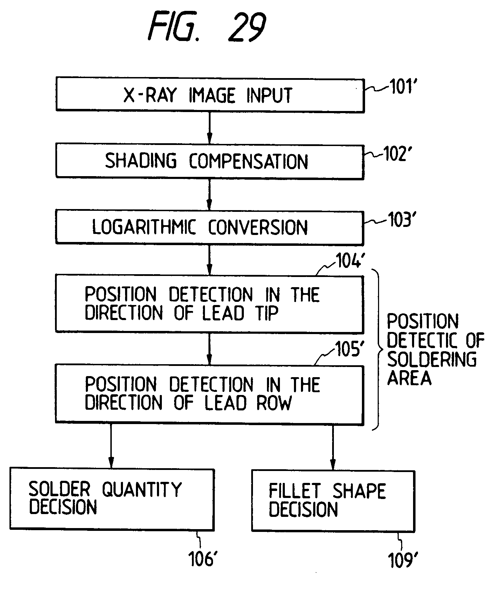

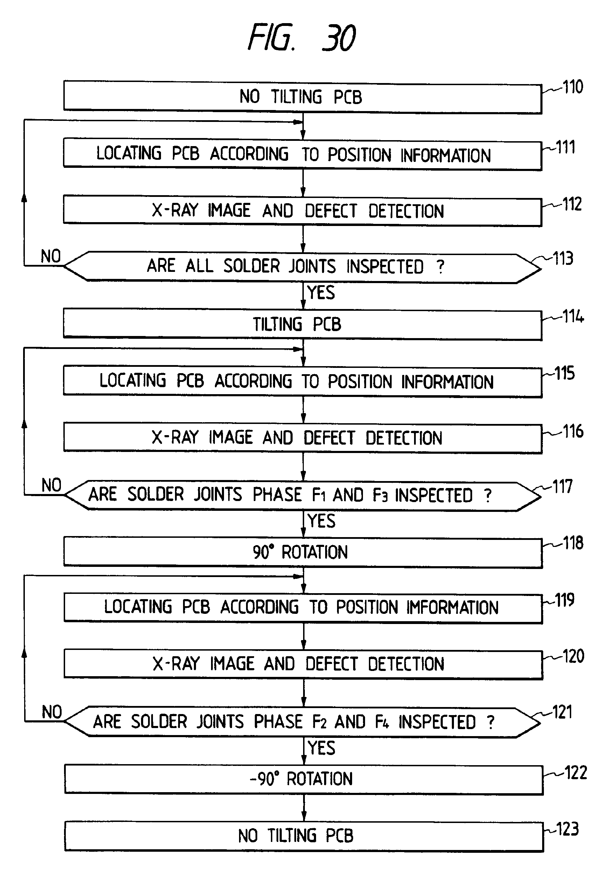

In sum, FIG. 28 shows a flow of image processing when a substrate is not tilted such as the case of one surface mounting (when a substrate is not tilted at $\varphi$), FIG. 29 shows a flow of image processing when a substrate is tilted (when a substrate is tilted at $\varphi$), and FIG. 30 shows a flow of inspection of a dual mounted substrate. In FIG. 30, the phase termed refers to a quadrant (phase) of a lead of a solder joint of an IC (part) 1 to be inspected. In this embodiment, clockwise numbers $F_1$ to $F_4$ are indicated. Flows of FIGS. 28 and 29 will be explained in connection with the hard structure of FIG. 8. Reference numerals 101, 101' designate the operation of TV camera 6 and A/D converter 11 shown in FIG. 8; 102, 102' the operation of the shading compensation circuit 12; and 103, 103' the operation of the logarithmic conversion circuit 13. The image is inputted into the memory 14 by 103 and 103'. 104 and 104' and 105, 105' designate the solder joint extraction processing in which the CPU 8 analyzes the horizontal and vertical projections prepared by 23 and 24. 106, 106', and 107 designate the defect decision processing in which the CPU 8 analyzes the vertical projection prepared by the vertical projection generating circuit 24. 108 designates the defect decision processing in which the CPU 8 analyzes the projection prepared by the projection generating circuit 26. 109 and 109' designate the defect decision processing in which the CPU 8 receives the image date from the memory 14 with the position of the solder joint obtained by 104, 105 or 104', 105' used as a reference.

The inspection flow of FIG. 30 will be described in connection with the whole structure of FIG. 1. In 110, the CPU 8 actuates the $\varphi$ stage 7 through the stage control unit 9. In 111, the CPU 8 actuates the XY$\theta$ stage 3 through the stage control unit 9. 112 indicates the processing operation shown in FIG. 28, which is carried out by the CPU 8 and the picture processing unit 10 shown in FIG. 1. 113 designates the processing carried out by the CPU 8. 114 designates the process in which the CPU 8 actuates the $\varphi$ stage 7 through the stage control unit 9. 115 has the same function as that of 111. 116 designates the process shown in FIG. 29 which is carried out by 8 and 10. 117 designates the process carried out by the CPU 8. 118 denotes the process in which the CPU 8 actuates the stage 3 through the stage control unit 9. 119 and 120 designate the same process as that of 115 and 116. 121 designates the process carried out by the CPU 8. 122 and 123 designate the process in which the step is returned to the original state upon completion of inspection, in which operation, the stages 3 and 7 are actuated by the CPU 8.

While in the present embodiment, a soldering image is used as a position of a solder joint, it is to be noted that a lead frame of a part or a target mark provided on the lead frame may be used.

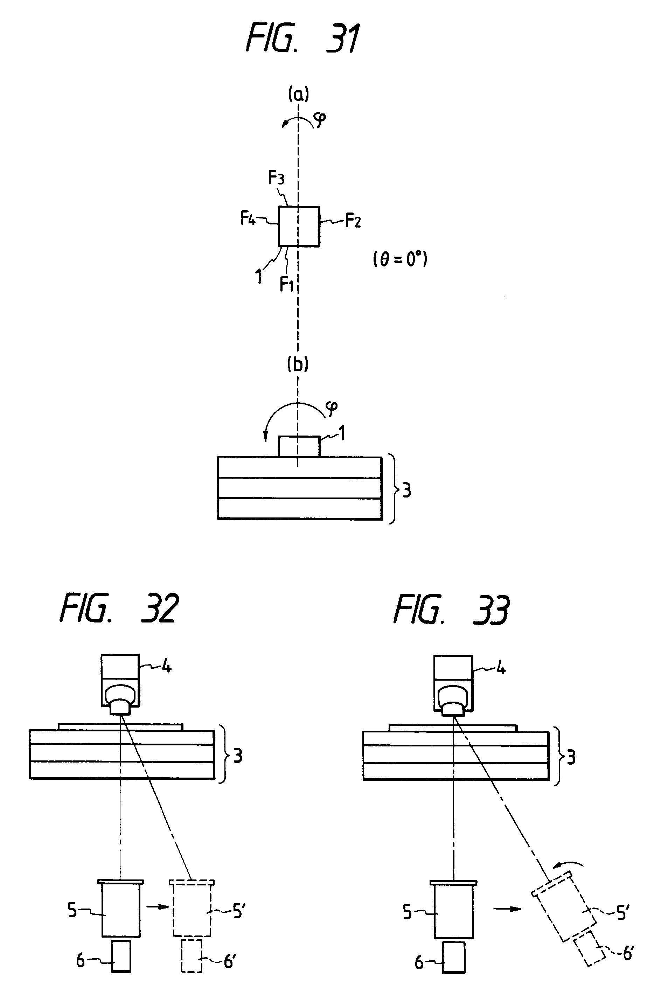

While in the present embodiment, since a substrate is tilted, the $\varphi$ stage 7 is relatively used, it is to be noted that a stage on which a substrate (printed board) 2 is placed may be made to possess the tilting function or only the image intensifier 5 and TV camera 6 may be moved as shown in FIGS. 32 and 33.

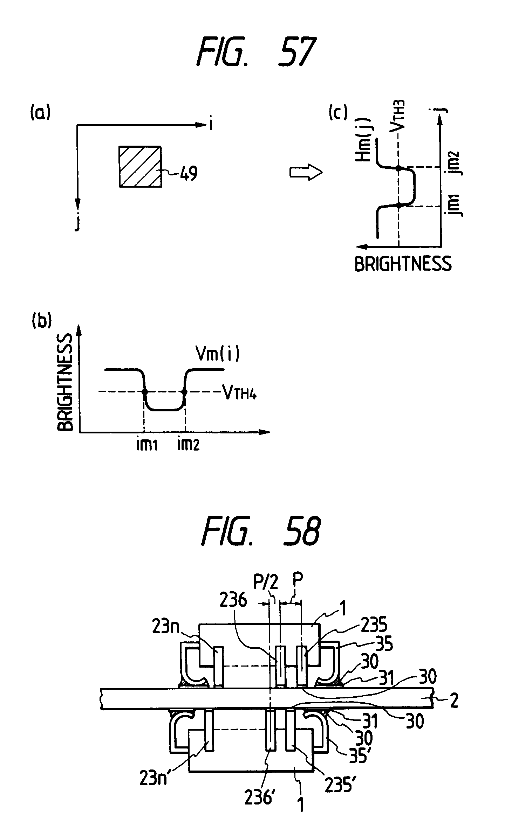

In the above-described embodiment, in the dual mounted substrate, the substate is tilted so that the inside and outside solder joints are not overlapped. However, alternatively, as shown in FIG. 58, a position at which parts 1 such as IC are placed on the inside and out side of the substrate 2 is deviated by 1/2 pitch portion of the spacing P between the leads, that is, P/2, and the parts are mounted whereby the inside and outside solder joints can be separated and detected without tilting the substrate.

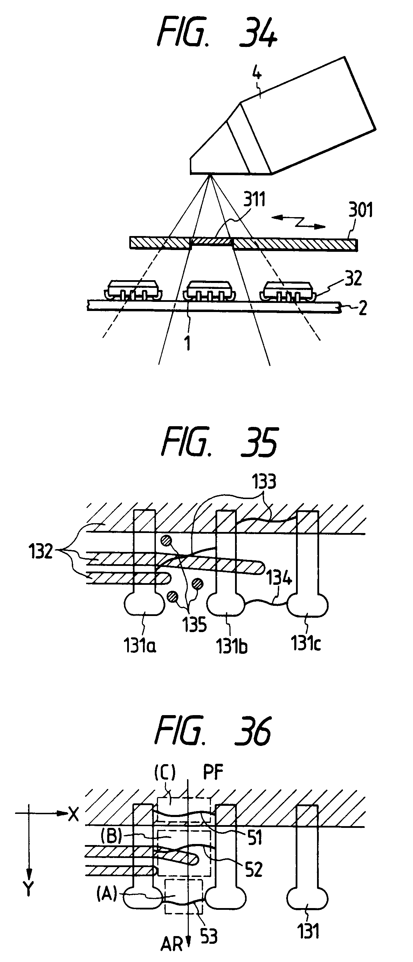

It is known that if the X-ray is large in amount of irradiation, a damage is given to an element. In the present invention, as shown in FIG. 34, a shutter 301 is provided so that the X-ray is merely irradiated on the IC part 1 during inspection. A filter 311 is provided to filtrate the X-ray on the solder joint. The shutter 301 is formed of Pb having a thickness of approximately 1 mm, and the filter 311 is formed of Cu having a thickness of approximately 0.1 to 0.2 mm. The filter 311 can reduce a damage to the element without affecting the soldering image in order to reduce a proportion of a long portion of a waveform of the X-ray. In order to reduce the damage to the element, there can be provided an X-ray shield plate in the state wherein mask patterns for shielding the X-ray are superposed on the portion of the element or on the part itself.

While in the present embodiment, the image intensifier and the TV camera have been used as an X-ray detector, it is needless to say that a configuration of using a fluorescent plate, a high sensitive camera and an X-ray TV camera may be employed.

As described above, according to the present embodiment, it is possible to automatically extract a position of a solder joint from an X-ray transmitted image signal and to automatically inspect a defect of a solder joint.

Next, an embodiment of the present invention will be described hereinafter with reference to FIG. 3(d), FIG. 4(b) and FIGS. 35 to 44.

FIG. 3(d) shows an example of a surface mounted part as an object of the present invention. FIG. 4(b) shows a sectional shape of an IC part in the soldered state. FIG. 35 shows an example of an X-ray image by which a solder joint of such a part is detected, an IC lead image 132 within a part package along with the lead 32 of a part and solders 131a to 131b on the substrate pad are similarly overlapped and detected. Reference numerals 133 and 134 designate an example of a bridge, and 135 an example of a defect of a soldering ball, respectively. In the case where a defect such as a fine soldering bridge as shown at 133 occurs in an area detected while being overlapped with a lead, it is present mixed with the lead image, and therefore it is difficult to discriminate and decide the bridge with high accuracy. The present invention provides a method for the decision to solve the aforesaid problem, which will be described in detail by use of a soldering bridge.

The formation of the X-ray fluoroscopic image in the J lead is as previously mentioned as shown in FIG. 4(b), FIGS. 8 to 10, and FIGS. 12a to FIG. 17.

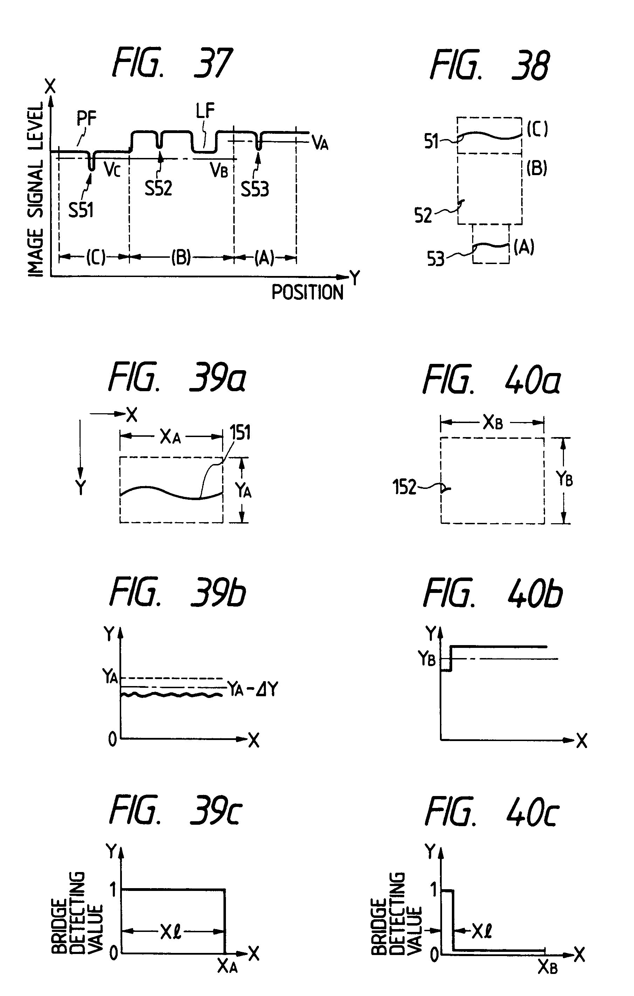

A method for deciding a soldering bridge according to the present invention executed by the CPU using an image of a solder joint of a lead detected as shown in FIG. 35 will be described hereinafter. In accordance with the positional coordinate of each lead obtained as described above, as shown in FIG. 36, an area is divided, between leads, into (A) an area in which no lead image is present, (B) an area in which a pattern image LF of a lead is detected, and (C) an area in which a flat plate-like lead image PF is detected, these areas being separated from the background of a substrate, a lead image or the like in each area, and a theshold is set to the highest level in the range in which only a soldering bridge image can be actualized to obtain a binary image. FIG. 36 shows an example in which fine soldering bridges (of which aborption relative to the X-ray is smaller than a lead) 51 to 53 are present. In FIG. 36, an image signal at a position shown at arrow AR is one shown in FIG. 37.

In FIGS. 36 and 37, PF is a flat plate-like lead portion, and LP is a lead pattern portion. In FIG. 37, S51, S52 and S53 are bridge image signals produced in soldering bridges 51, 52 and 53, respectively. As will be apparent from these figures, if in the areas (A), (B) and (C), $V_A$, $V_B$ and $V_C$ are used to obtain a binary image, an image signal (FIG. 38) separated from the background to actualize only a bridge is obtained in each area. That is, according to the present method, in the areas (A), (B) and (C), a binary image in which soldering bridges 53 and 51 are completely actualized is obtained, and a bridge decision is carried out using the binary image.

A method for the decision will be described with reference to FIGS. 39a to 39c by way of an example of processing in the area (A).

First, in the binary image caused by the image $V_A$ shown in FIG. 39a, a distribution (FIG. 39b) in the direction of X of the number of picture elements of a portion with no solder in the case of counting in the direction of Y is obtained to calculate a bridge detection value (FIG. 39c) corresponding to the range of less (YA - $\Delta$Y) with respect to the length YA in the direction of Y of the processing area. Next, the width $X\ell$ in the direction of X is obtained as a bridge length, and when a difference between said width and the width XA in the direction of X of the processing area is smaller than a predetermined value $\varepsilon$ (condition XA - X $\ell \leq \varepsilon$), the presence of bridge is decided. In the FIG. 39c example, XA - $X\ell$ = 0 results, and the presence of bridge can be decided.

For the bridge 51 in the area (C), similar effect is obtained. In the decision area (B), as shown in an example of FIG. 36, in the case where a soldering bridge 52 lower in contrast than the image of the lead 32 is present, as shown in FIGS 40a to 40c a soldering bridge image of a portion superposed to the image of the lead 32 can be placed in good shape but a soldering bridge image produced at a position not superposed to the lead 32 cannot be detected. Accordingly, it is not reflected upon a bridge obtained in FIG. 40c, and sufficient detection accuracy cannot be obtained.

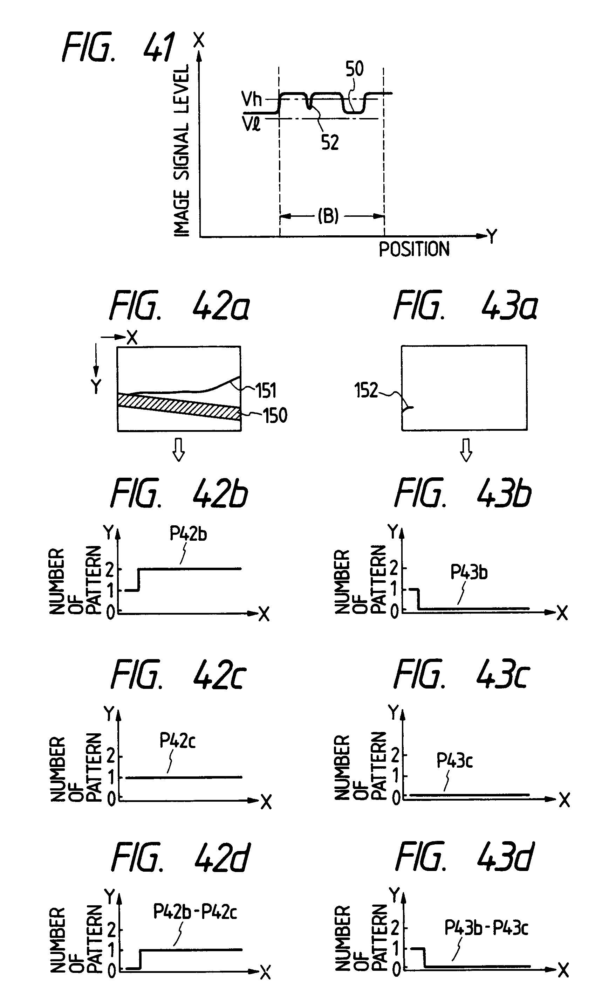

In the present embodiment, for the area (B) shown in FIG. 41 in which a pattern image 50 of the lead 32 is detected, a bridge decision according to the method which will be described later is carried out. As shown at an image signal level (axis X) in FIG. 41, two thresholds Vh and V$\ell$ are used for the area (B) to prepare two kinds of binary images. That is, Vh is a threshold level at which a lead portion is separated from a printed circuit board 2 to place it in good shape, and V$\ell$ is the same level as VB explained in FIG. 37, that is, V$\ell$ = VB, which is the maximum of the range in which the lead 32 is not detected. FIGS. 42a to 42d show examples of the aforesaid two kinds of binary images with respect to the area (B) in the FIG. 36 example.

In the present embodiment, pattern number distributions (axis Y direction) in which the number of patterns when searched in the direction of axis Y is counted every picture element of each coordinate X are obtained as shown in FIGS. 42b and 43b (the distributions being indicated at P42b and P43b). These are compared with reference pattern number distributions (indicated at P42c and P43c in FIGS. 42c and 43c) likewise obtained in advance using a good sample to obtain a difference therebetween, the result of which is shown at (P42b - P42c) and (P43b - P43c) in FIGS. 42d and 43d, respectively.

For those in which either the aforesaid result has a difference, the presence of a bridge defect is decided. Reference numeral 151 of FIG. 42a and 152 of FIG. 43a denote a bridge, and 150 denotes a pattern of a lead.

It is understood from the examples of FIGS. 42d and 43d that in both the results for decision of images, a difference is recognized and the bridge decision can be made. If a method for ignoring a difference of a fine width is employed for the results of (P42b - P42c) and (P43b - P43c), it is possible to remove an erroneous decision affected by noises or the like.

While in the foregoing, a description has been made using an example of a soldering bridge, it is noted that according to the present invention, a defect of a soldering ball or the like can be likewise detected.

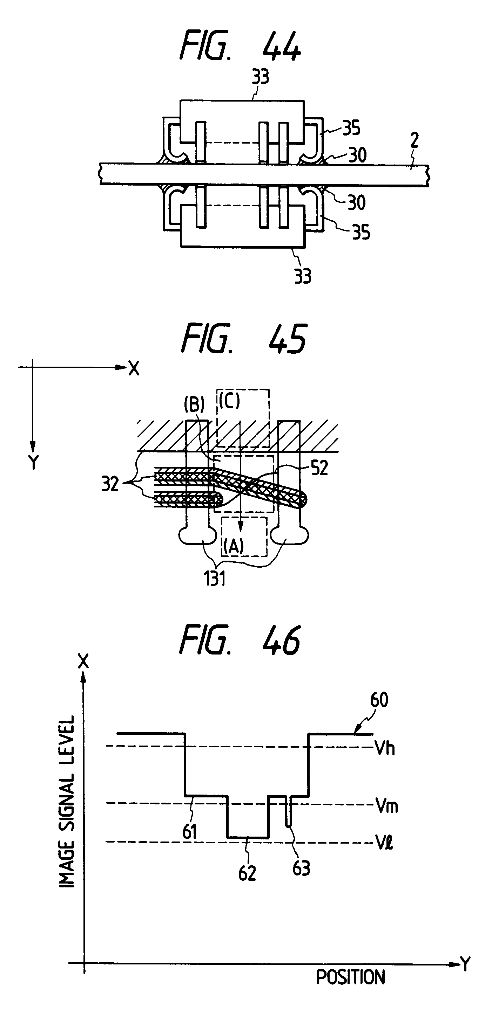

The present embodiment can be also applied to an inspection of a soldering bridge on a substrate 2 as shown in FIG. 44 in which parts 1 having a J lead 32 are mounted on both surfaces. In such a mounted substrate, the parts 1 having the inside and outside J leads are mounted substantially at the same position. Therefore, the image detected and processed by the method shown in FIG. 1 is as shown in the example of FIG. 45. In the Figure, reference numeral 32 designates a lead, 52 a soldering bridge and 131 the other lead, respectively.

Accordingly, if a portion between leads is divided into decision areas (A), (B) and (C) corresponding to the position of the image of the lead 32 in a manner similar to the method shown in FIG. 36, in the area (A) in which the image of the lead 32 is not present and the area (C) in which the image of the flat plate-like lead 32 is detected, the bridge decision can be made by using the method similar to those shown in FIGS. 39 (1a) to (3a). However, in the area (B), as shown in FIG. 45, a portion in which a pattern image of the lead 32 among the inside and outside ICs is superposed and that not superposed occur due to the fine misalighment of position of the inside and outside J lead parts 1. Therefore, the image signal waveform of the portion as indicated by the arrow in FIG. 45 is as shown in FIG. 46. In the embodiment, three thresholds Vh, Vm and V$\ell$ are provided. The Vh is a level in which images of all the leads 32 detected at a darker level (low image signal level) than a level (material level) 60 of the printed circuit board 2 can be separated from the material and actualized in the area (B). The Vm is a level in which a superposed portion of the inside and outside leads can be actualized. The V$\ell$ is a level in which an image at a darker level than superposed portions 61 and 62 of the lead can be actualized.

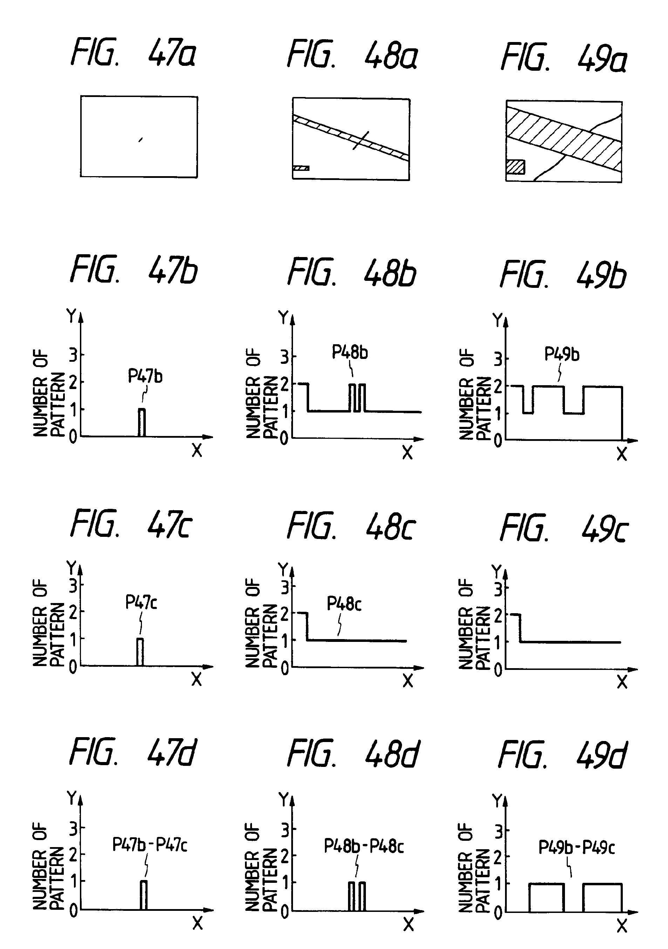

When binarized images are prepared from the Vh, Vm and V$\ell$ in the region (B), they are as shown in the examples of FIGS. 47a, 48a and 49a. With respect to the respective images, pattern number distributions P47b, P48b and P49b when searched in the direction of Y are obtained in a manner similar to the method shown in FIGS. 42a to 42d and 43a to 43d, and these are compared with the pattern number distributions P47c, P48c and P49c obtained in advance in a similar manner to the former with respect to good product reference to obain differences P47b-P47c, P48b-P48c and P49b-P49c. If any difference is recognized, the bridge can be decided, enabling realization of inspection with high accuracy.

In the case of this example, all the results have a difference, thus rendering inspection of bridge possible. Alternatively, if a good reference pattern is stored in advance as a binary image, and if an image obtained from a difference between the reference pattern image, the image of FIG. 47a and the image of FIG. 48a is obtained, the bridge can be actualized. It is possible to decide a bridge by the method shown in FIGS. 39a to 39c and 40a to 40c using the aforesaid image obtained from the difference.

As described above, according to the present embodiment, in inspecting the soldering of the mounted part using the X-ray as an inspecting means, influences from the lead image of the IC part or the like can be removed. Therefore, high detection performance even with respect to a fine soldering bridge produced between the part leads can be obtained.

Another embodiment of the present invention will be described hereinafter.

FIG. 3 shows an example of a surface mounted part as an object in the present embodiment. FIG. 4 shows a sectional shape of IC in the soldered state.

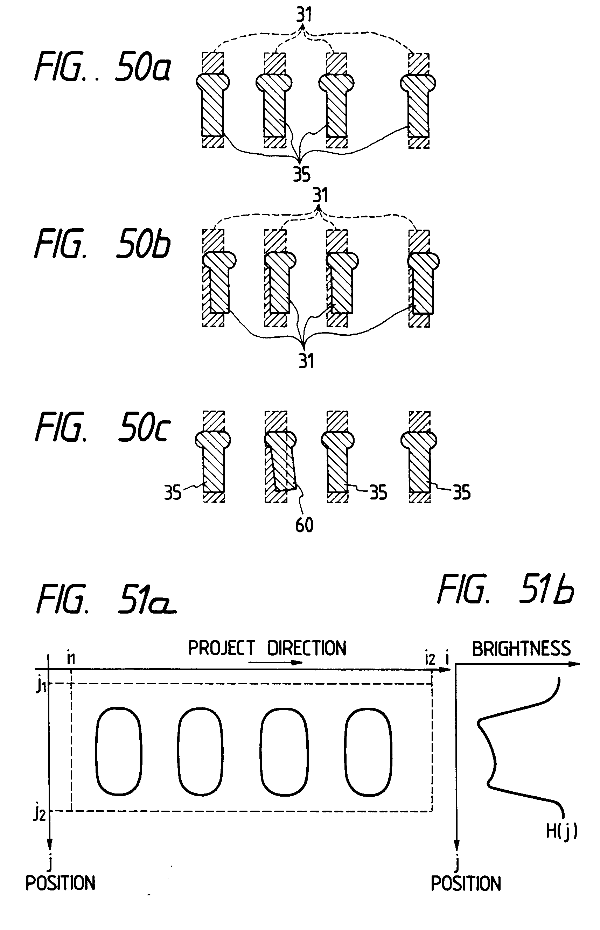

FIGS. 50a to 50c show an example of an X-ray image in which a solder joint of such a part is detected. Particularly, an example of J lead will be described. FIG. 50a shows an example of an image of a normal solder joint, in which a part lead 3a and a pad 31 on the circuit board are superposed and detected. FIG. 50b shows an example of an X-ray image in the case where a defect in misalignment of position at which IC is mounted occurs. FIG. 50c shows an example of an X-ray image in the case where a defect 60 in lead bend occurs. The formation of an X-ray fluoroscopic image in the J lead is as described previously.

For the X-ray fluoroscopic image of the J lead obtained in the manner as described above, the picture processing unit is used to obtain a horizontal projection j in an area as shown in FIG. 51a.

A calculation equation for a horizontal projection H(j) with resepct to an image f(i,j) is given below.

$$H(j) = \sum_{i=i_1}^{i_2} f(i, j) \qquad \ldots (9)$$

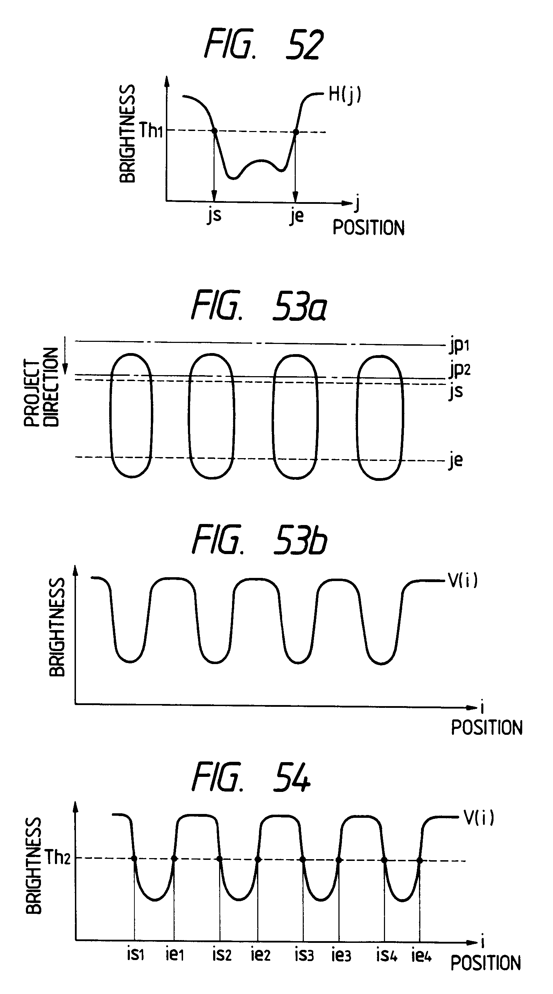

As the result, the horizontal projection H(j) as shown in FIG. 51b is obtained. The CPU 8 receives H(j) to obtain points of intersection js and je with the threshold $Th_1$ and the horizontal projection H(j) as shown in FIG. 52, which are used as positions of the vertical solder joints. Here, the threshold $Th_1$ is set in advance, or a value is used which is subjected to internal division at a ratio set in advance by the maximum and minimum of the inputted horizontal projection H(j).

Next, areas $jp_1$ and $jp_2$ moved through a predetermined amount with respect to js and je as shown in FIG. 53a are calculated, and a vertical projectin V(i) in the areas $jp_1$ to $jp_2$ is obtained using the picture processing unit 10. The $jp_1$ to $jp_2$ correspond to the area in which a part of a pad of a solder joint to be detected externally of the lead tip portion is present and can be obtained, for example, by the following equations:

$$\begin{aligned} jp_1 &= 1/2 \ (js + je) - \Delta j_1 \\ jp_2 &= 1/2 \ (js + je) - \Delta j_2 \end{aligned} \bigg) \quad \ldots (10)$$

The method for calculation of the vertical projectin V(i) is expressed by the following formula.

$$V(i) = \sum_{j=jp_1}^{jp_2} f(i, j) \qquad \ldots (11)$$

An example of V(i) obtained is shown in FIG. 53b. The CPU receives V(i) to obtain points of intersection $is_1$, $ie_1$ to $is_4$, $ie_4$ between the threshold Th2 and V(i), which use as positions of vertical pad. This is similar to the setting of the threshold Th2.

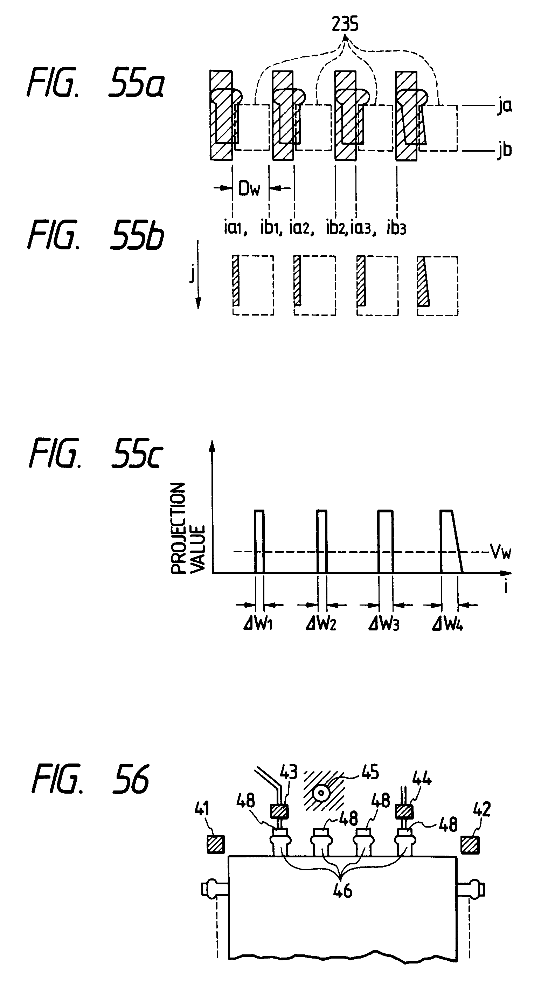

In the CPU 8, a misalighment decision area 235 is provided between pads as shown in FIG. 55a with the pad positions js, je, and $is_1, ie_1$ to $is_4$, $ie_4$ obtained as described above used as a reference. This area may be set as follows, for example.

$$ja = js + A, jb = je + B$$
$$ia_1 = 1/4 \ (is_1 - ie_1 + is_2 + ie_2) - 1/2 \ D_W$$
$$ib_1 = 1/4 \ (is_1 + ie_1 + is_2 + ie_3) + 1/2 \ D_W$$

where $D_W$ represents the decision area width.

Next, as shown in FIG. 55b, an image within each decision area 235 is binarized in the picture processing unit 10 to obtain a vertical projection value of a binary image. With respect to the waveform as in FIG. 55c obtained from the aforesaid projection value, waveform widths $\Delta W_1$ to $\Delta W_4$ crossed with a reference level $V_w$ set to the CPU 8 are calculated by the CPU 8, and when the waveform widths are larger than a predetermined allowable value, a misaligned lead is decided.

Also, in the case where the printed circuit board 2 as an object to be inspected is a dual mounted substrate as shown in FIG. 44, an X-ray image obtained by the detection method as shown in FIG. 12 is detected as a single image in which the inside and outside substrate pads are superposed. A normal lead as well as the inside and outside leads are detected in a superposed mode as shown in FIG. 50a, and in case where a misalignment of at least one lead is present, an image forced out between the pads can be detected as shown in FIG. 50b and 50c. Therefore, the decision of the misalignment in position of lead can be executed similarly to the aforementioned dual mounted substrate.

FIG. 56 shows another embodiment for obtaining a setting position of a misaligned lead decision area provided between the substrate pads. In the other first method, reference patterns 41 and 42 for recognition of position are provided in advance in a vacant space on the printed circuit board 2 as shown in FIG. 56. In the step of coating a solder paste when the circuit board is assembled, the solder is also coated on the reference patterns 41 and 42 for recognition of position so as to obtain a high contrast image when the X-ray image is detected. Reference numeral 45 designates a through hole.

At the time of decision of a misaligned lead, horizontal and vertical projections $Hm(j)$ and $Vm(i)$ are obtained in connection with each reference pattern 49 for recognition of position as shown in FIG. 57 to calculate points of intersection $jm_1$, $jm_2$, $im_1$ and $im_2$ with predetermined thresholds $V_{TH3}$ and $V_{TH4}$ by the CPU 8. After this calculation has been done in connection with the position recognition reference patterns 41 and 42, the relative position coordinate value between the position recognition reference patterns 41 and 42 inputted into the CPU in advance and the value of the pad dimension are used to set a misaligned lead decision area between the pads.

In the other second method, as shown at 43 and 44 in FIG. 56, a position recognition reference pattern is provided at a position close to a substrate pad 48 to set a misaligned lead decision area in a method similar to the former. In the third method, as shown at 45 in FIG. 56, a clearance pattern by which a particularly high contrast image is obtained is used as a reference to set a misaligned lead decision area. Even if this method is used, a misaligned lead decision area can be set in a method similarly when the aforesaid position recognition reference pattern is applied.

As described above, according to the present invention, in inspecting a soldering of a mounted part by use of the X-ray as detection means, it is possible to detect an amount of a misaligned position of lead with respect to the substrate pad with high accuracy.

FIG. 58 is a view showing a construction of mounting electronic parts onto a substrate to which the inspection method of the present invention as described above can be easily applied. Solder joints 30 provided on leads 235, 236, ... 23n and 235′, 236′, ... 23n′ provided on the opposite sides of the substrate 2 are arranged with a pitch P, and arranged with a pitch deviated by P/2 one to the other so that the X-ray transmitted images of the leads or the like obtained by the X-ray irradiated from one side of the substrate 2 are not superposed between the images on the opposite sides.

The thus structured electronic-part mounting construction is an apparatus provided with an effective construction in that the aforementioned inspection according to the present invention can be carried out by simple means without tilting the substrate.

## Claims

1.  A method for inspecting a solder joint (30) for use with X-ray fluoroscopic imaging apparatus (4, 5, 6, 7), the method comprising the steps of:

    obtaining an X-ray fluoroscopic image signal by irradiating an X-ray on an object (1, 2) to be inspected which is located by a specimen stage (3) and is formed by soldering a lead (32, 32′) of an electronic part (1) to a substrate (2) at said solder joint (30),

    extracting a position of said solder joint (30) of said object (1, 2) to be inspected from said obtained X-ray fluoroscopic image signal,

    defining, from the X-ray fluoroscopic image signal, a plurality of inspection areas on a solder portion and a peripheral portion of the solder joint (30) in accordance with the extracted position of said solder joint (30),

    **characterized** by the further steps of:

    collecting X-ray fluoroscopic image signal shapes $GW_1$ to $GW_M$ obtained from many good solder joints judged as good solder joints in advance; dividing the solder joints having similar shapes to each other into a plurality of classes as one class by clustering many collected X-ray fluoroscopic image signal shapes $GW_1$ to $GW_M$; extracting typical X-ray fluoroscopic image shapes $S_1$ to $S_N$ from the X-ray fluoroscopic image signal shape of each of said divided classes, and preparing a plurality of reference image

signal shapes $S_1$ to $S_N$ corresponding to the shape variations of the good solder joints;
comparing each of a plurality of said prepared reference image signal shapes $S_1$ to $S_N$ with the X-ray fluoroscopic image signal shape W obtained from the inspection area of the solder joint (30) to be inspected and indicating a defect in said solder joint (30) when the value min $|W - Sj|$, j = 1, ..., N exceeds or equals a prededetermined reference.

2.    A method according to claim 1,
wherein the extracting step includes said position of the solder joint (30) by extracting
i) a position of a lead (32, 32') in a lead tip j-direction by a horizontal distribution projection with said X-ray fluoroscopic image signal projected in a lead row direction, and
ii) a position of a lead in a row direction by a vertical distribution projection with said X-ray fluoroscopic image signal projected in a lead tip i-direction.

3.    A method according to claim 1, further comprising the step of detecting a defect of a deviated lead i.e. mis-aligned lead by comparing at least one of a width $i_{sn} - i_{en}$, (n = 1-4) and a spacing $i_{en} - i_{sn+1}$ of the solder joint (30) detected from said X-ray fluoroscopic image signal for said each defined inspection area of a solder portion with a reference value.

4.    A method according to claim 1,
further comprising detecting a defect of solder amount by evaluating an amount of solder at each of a plurality of solder joints (30) by integrating the X-ray fluoroscopic image signal for said each defined inspection area of solder portion.

5.    A method according to claim 1,
wherein the detecting step includes detecting said defect between each of a plurality of solder joints (30) in accordance with a binary image converted from the X-ray fluoroscopic image signal for said each defined inspecticn area of said peripheral portion between the plurality of solder joints.

6.    A method according to claim 1,
further comprising the steps of relatively tilting said X-ray and an object (1, 2) to be inspected whereby inside and outside solder joints (30, 30) with electronic parts (1, 1) mounted on both surfaces on said substrate (2) respectively are not superimposed to obtain said X-ray fluoroscopic image signal.

7.    A method according to claim 6,
wherein the defining step includes collectively defining a set of inside and outside solder joints as said plurality of inspection areas.

8.    A method according to claim 1,
wherein a plurality of reference image signal shapes of good solder joint (30) are prepared for deriving said reference image signal shape of a good solder joint.

9.    A method according to claim 1,
wherein said comparing step includes comparison between said X-ray fluoroscopic image signal shape and the reference image signal shape of a good solder joint by integration of each difference image signal provided by said comparison and wherein said method comprises a step of deciding a quality of a solder joint by a minimum of said integrated value of said difference.

10.  A method according to claim 1,
further comprising actualizing only solder for every inspection area on the peripheral portion of the solder joint (30) using a threshold to convert the X-ray fluoroscopic image signal into a binary image signal, and comparing said actualized binary image signal and a binary image signal of a good solder joint to detect at least one of a soldering bridge and a soldering ball present between the leads (32, 32') with respect to an X-ray fluoroscopic image signal of a normal area between said leads.

11.  The method according to claim 1,
wherein the extracting step includes using a predisposed pattern within said electronic part (1) as a position reference.

12.  The method according to claim 1,

wherein the extracting step includes using a predisposed pattern (41, 42, 43, 44) formed on said substrate (2) as a position reference.

13. The method according to claim 1,
further comprising obtaining said reference image signal shape of good solder joints from an X-ray fluoroscopic image signal shape of a typical good solder joint .

14. The method according to claim 13,
further comprising obtaining the X-ray fluoroscopic image signal shape of said typical good solder joints by clustering signals of good solder joints with respect to X-ray fluoroscopic images of a number of good solder joints.

15. The method according to claim 1,
further comprising using an image signal subjected to natural logarithmic conversion with respect to the X-ray fluoroscopic image as said X-ray fluoroscopic image signal.

16. An apparatus for inspecting a solder joint (30) using X-ray fluoroscopic imaging, the apparatus comprising:
means (4) for irradiating an X-ray generated from an X-ray source;
a specimen stage (3) for locating an object (1, 2) to be inspected having a lead (32, 32') of an electronic part (1) soldered to a substrate (2);
an X-ray detector (5, 6) for detecting an X-ray fluoroscopic image obtained by transmitting said X-ray through solder joints (30) of the object (1, 2) located by said specimen stage (3);
solder-joint position extracting means (23, 24, 8) for extracting a position of each of the solder joints (30) of said object (1, 2) to be inspected in accordance with said X-ray fluoroscopic image signal detected by said X-ray detector (5, 6);
inspection-area setting means (8) for setting a plurality of inspection areas on each of i) a portion of a solder joint and ii) a peripheral portion of a solder joint (30), corresponding to each of the solder joints in accordance with the extracted position of each solder joint extracted by said solder joint position extracting means (23, 24, 8);
**characterized by**
means for collecting X-ray fluoroscopic image signal shapes $GW_1$ to $GW_M$ obtained from many good solder joints judged as good solder joints in advance;
means for dividing the solder joints having similar shapes to each other into a plurality of classes as one class by clustering many collected X-ray fluoroscopic image signal shapes $GW_1$ to $GW_M$;
means for extracting the typical X-ray fluoroscopic image shapes $S_1$ to $S_N$ from the X-ray fluoroscopic image shapes of each of divided classes;
means for preparing a plurality of reference image signal shapes $S_1$ to $S_N$ corresponding to the shape variations of the good solder joints;
means for comparing each of a plurality of said pre pared reference image signal shapes $S_1$ to $S_N$ with the X-ray fluoroscopic image signal shape W in the inspection area at the solder joint (30) to be inspected and
means for indicating a defect in said solder joint when the value $|W - Sj|$, $j = 1, ..., N$ exceeds or equals a predetermined reference.

17. An apparatus according to claim 16,
wherein said solder joint position extracting means includes means (23, 24, 8) for i) extracting a position of a lead (32, 32') in a lead tip j-direction by a horizontal distribution direction with said X-ray fluoroscopic image signal projected in a lead row direction, and ii) extracting a position of a lead in a row direction by a vertical distribution projection with said X-ray fluoroscopic image signal in a lead tip i-direction.

18. An apparatus according to claim 16,
wherein said defect detecting means (8, 25, 26) includes means for detecting a defect of deviated lead (mis-aligned lead) by comparing at least one of a width and a spacing of the solder joint (30) detected from said X-ray fluoroscopic image signal for said each set inspection area of solder portion, with a reference value.

19. An apparatus according to claim 16,

16

wherein said defect detecting means (8, 25, 26) includes means for detecting a defect of solder amount by evaluating an amount of solder at each of a plurality of solder joints by integrating the X-ray fluoroscopic image signal for said each set inspection area of solder portion.

20. An apparatus according to claim 16,
wherein said defect detecting means (8, 25, 26) includes means for detecting said defect between each of a plurality of solder joints in accordance with a binary image converted from the X-ray fluoroscopic image signal for said each set inspection area of said peripheral portion between the plurality of solder joints.

21. An apparatus according to claim 16,
wherein said X-ray detector further comprises means (7) for obtaining an X-ray fluoroscopic image so that inside and outside solder joints electrical parts mounted on both surfaces of said substrate respectively thereof are not superimposed .

22. An apparatus according to claim 21,
wherein said inspection area setting means comprises means for collectively setting a set of inside and outside solder joints as said plurality of inspection areas.

23. An apparatus according to claim 22,
wherein said inspection area setting means further comprises means for dividing each of inspection areas of the X-ray fluoroscopic image corresponding to a solder joint into two inspection areas corresponding to two parts whereby the defect of inside and outside can be separated.

24. An apparatus according to claim 16,
further comprising logarithmic conversion means (13) for subjecting said X-ray fluoroscopic image signal obtained from said X-ray detector (5, 6) to natural logarithmic conversion as said X-ray fluoroscopic image signal.

25. An apparatus according to claim 16,
wherein said defect detecting means further comprises means for preparing a plurality of reference image signal shapes of good solder joint.

26. An apparatus according to claim 16,
wherein said defect detecting means further comprises comparing means for comparing betwen said X-ray fluoroscopic image signal shape and the reference image signal shape of good solder joint by integration of each difference image signal provided by said comparison.

27. An apparatus according to claim 16,
further comprising rotate means (7) for rotating the optical axes of said X-ray source (4) and said X-ray detector (5, 6) to relatively tilt said object to be inspected.

28. An apparatus according to claim 16,
wherein said X-ray detector (5, 6) comprises tilt means for relatively tilting said object to be inspected.

29. An apparatus according to claim 16,
further comprising shield means (301, 311) for reducing X-ray damage to the object.

30. An apparatus according to claim 16,
wherein said defect detecting means comprises means for converting said X-ray fluoroscopic image signal into a binary image signal by use of a threshold for actualizing only solder for every inspection area on the peripheral portion of the solder joint (30) set by said area setting means and binary signal comparison means for comparing said converted binary image signal and a binary image signal of a good solder joint to detect at least one of a soldering bridge and a soldering ball present between the leads (32, 32') with respect to an X-ray fluoroscopic image signal of a normal area between said leads.

31. An apparatus according to claim 16, further comprising means for comparing a number of patterns of said binary image signal and binary image signals of a good solder joint.

**Patentansprüche**

1. Verfahren zum Prüfen einer Lötstelle (30), das in einer röntgenfluoroskopischen Bilderzeugungsvorrichtung (4, 5, 6, 7) verwendet wird, wobei das Verfahren die Schritte enthält:

   Erhalten eines röntgenfluoroskopischen Bildsignals durch Bestrahlen eines zu prüfenden Gegenstandes (1, 2) mit Röntgenstrahlen, wobei sich der Gegenstand auf einer Probenbühne (3) befindet und durch Anlöten einer Anschlußleitung (32, 32′) eines elektronischen Teils (1) an ein Substrat (2) an der Lötstelle (30) gebildet wird,

   Entnehmen einer Position der Lötstelle (30) des zu prüfenden Gegenstandes (1, 2) aus dem erhaltenen röntgenfluoroskopischen Bildsignal,

   Definieren von mehreren Prüfbereichen in einem Lötabschnitt und einem Umgebungsabschnitt der Lötstelle (30) entsprechend der entnommenen Position der Lötstelle (30) anhand des röntgenfluoroskopischen Bildsignals, **gekennzeichnet** durch die weiteren Schritte:

   Sammeln von röntgenfluoroskopischen Bildsignalformen $GW_1$ bis $GW_M$, die aus vielen guten Lötstellen erhalten werden, die im voraus als gute Lötstellen beurteilt worden sind; Einteilen der Lötstellen mit untereinander ähnlichen Formen in mehrere Klassen, wobei eine Klasse durch Häufen vieler gesammelter röntgenfluoroskopischer Bildsignalformen $GW_1$ bis $GW_M$ geschaffen wird; Entnehmen typischer röntgenfluoroskopischer Bildsignalformen $S_1$ bis $S_N$ aus den röntgenfluoroskopischen Bildsignalformen jeder der eingeteilten Klassen und Vorbereiten mehrerer Referenzbildsignalformen $S_1$ bis $S_N$, die den Formschwankungen der guten Lötstellen entsprechen;

   Vergleichen jeder der mehreren vorbereiteten Referenzbildsignalformen $S_1$ bis $S_N$ mit dem röntgenfluoroskopischen Bildsignal W, das aus dem Prüfbereich der zu prüfenden Lötstelle (30) erhalten wird, und Anzeigen eines Defekts in der Lötstelle (30), wenn der Wert min $|W - Sj|$, $j = 1, ..., N$ einen vorgegebenen Referenzwert übersteigt oder diesem gleich ist.

2. Verfahren nach Anspruch 1,

   bei dem der Entnahmeschritt die Position der Lötstelle (30) enthält, indem

   i) eine Position einer Anschlußleitung (32, 32′) in einer j-Richtung einer Anschlußleitungsspitze durch eine horizontale Verteilungsprojektion mit dem in einer Anschlußleitungsreihen-Richtung projizierten röntgenfluoroskopischen Bildsignal entnommen wird und

   ii) eine Position einer Anschlußleitung in einer Reihenrichtung durch eine vertikale Verteilungsprojektion mit dem in einer i-Richtung der Anschlußleitungsspitze projizierten röntgenfluoroskopischen Bildsignal entnommen wird.

3. Verfahren nach Anspruch 1, ferner mit dem Schritt des Erfassens eines Defekts einer abweichenden Anschlußleitung, d.h. einer fehlausgerichteten Anschlußleitung, indem wenigstens entweder die Breite $i_{sn} - i_{en}$ (n = 1-4) oder der Abstand $i_{en} - i_{sn\pm1}$ der Lötstelle (30), die aus dem röntgenfluoroskopischen Bildsignal für jeden definierten Prüfbereich eines Lötabschnitts erfaßt werden, mit einem Referenzwert verglichen wird.

4. Verfahren nach Anspruch 1,

   ferner mit der Erfassung eines Lötmittelmengen-Defekts durch Auswerten einer Lötmittelmenge in jeder von mehreren Lötstellen (30), indem das röntgenfluoroskopische Bildsignal für jeden definierten Prüfbereich eines Lötabschnitts integriert wird.

5. Verfahren nach Anspruch 1,

   bei dem der Erfassungsschritt für jeden definierten Prüfbereich des Umgebungsabschnitts zwischen den mehreren Lötstellen die Erfassung des Defekts zwischen jeder von mehreren Lötstellen (30) entsprechend einem binären Bild enthält, das aus dem röntgenfluoroskopischen Bildsignal umgewandelt worden ist.

6. Verfahren nach Anspruch 1,

   ferner mit den Schritten des relativen Neigens des Röntgenstrahls und eines zu prüfenden Gegenstandes (1, 2), wobei innere und äußere Lötstellen (30, 30) mit auf beiden Oberflächen des Substrats (2) angebrachten elektronischen Teilen (1, 1) nicht überlagert werden, um das röntgenfluoroskopische Bildsignal zu erhalten.

7. Verfahren nach Anspruch 6,

   bei dem der Definitionsschritt die zusammenfassende Definition einer Menge von inneren und äußeren Lötstellen für die mehreren Prüfbereiche enthält.

8. Verfahren nach Anspruch 1,

bei dem mehrere Referenzbildsignalformen von guten Lötstellen (30) geschaffen werden, um die Referenzbildsignalform einer guten Lötstelle abzuleiten.

9. Verfahren nach Anspruch 1,

bei dem der Vergleichsschritt den Vergleich zwischen der röntgenfluoroskopischen Bildsignalform und der Referenzbildsignalform einer guten Lötstelle durch Integration jedes durch den Vergleich erhaltenen Differenzbildsignals enthält, wobei das Verfahren einen Schritt enthält, in dem die Qualität einer Lötstelle durch den minimalen integrierten Wert der Differenzen bestimmt wird.

10. Verfahren nach Anspruch 1,

ferner mit der Aktualisierung lediglich des Lötmittels für jeden Prüfbereich auf dem Umfangsabschnitt der Lötstelle (30) unter Verwendung eines Schwellenwerts, um das röntgenfluoroskopische Bildsignal in ein binäres Bildsignal umzuwandeln, sowie mit dem Vergleichen des aktualisierten binären Bildsignals und eines binären Bildsignals einer guten Lötstelle, um wenigstens eine Lötbrücke oder eine Lötkugel zu erfassen, die zwischen den Anschlußleitungen (32, 32') vorhanden ist, wenn auf ein röntgenfluoroskopisches Bildsignal eines normalen Bereichs zwischen den Anschlußleitungen Bezug genommen wird.

11. Verfahren nach Anspruch 1,

bei dem der Entnahmeschritt die Verwendung eines im voraus angeordneten Musters im elektronischen Teil (1) als Positionsreferenz enthält.

12. Verfahren nach Anspruch 1,

bei dem der Entnahmeschritt die Verwendung eines im voraus angeordneten Musters (41, 42, 43, 44) enthält, das auf dem Substrat (2) als Positionsreferenz ausgebildet wird.

13. Verfahren nach Anspruch 1,

mit dem Erhalten der Referenzbildsignalform von guten Lötstellen aus einer röntgenfluoroskopischen Bildsignalform einer typischen guten Lötstelle.

14. Verfahren nach Anspruch 13,

ferner mit dem Erhalten der röntgenfluoroskopischen Bildsignalform der typischen guten Lötstellen durch Häufen von Signalen von guten Lötstellen in bezug auf röntgenfluoroskopische Bilder einer Anzahl von guten Lötstellen.

15. Verfahren nach Anspruch 1,

ferner mit dem Verwenden eines Bildsignals, das einer Umwandlung mit natürlichem Logarithmus in bezug auf das röntgenfluoroskopische Bild unterworfen worden ist, als röntgenfluoroskopisches Bildsignal.

16. Vorrichtung zum Prüfen einer Lötstelle (30) unter Verwendung einer röntgenfluoroskopischen Bilderzeugung, wobei die Vorrichtung enthält:

eine Einrichtung (4) zum Abstrahlen eines von einer Röntgenquelle erzeugten Röntgenstrahls;

eine Probenbühne (3), auf der ein zu prüfender Gegenstand (1, 2) mit einer mit einem Substrat (2) verlöteten Anschlußleitung (32, 32') eines elektronischen Teils (1) angeordnet wird;

einen Röntgendetektor (5, 6), der ein röntgenfluoroskopisches Bild erfaßt, das durch Schicken des Röntgenstrahls durch die Lötstellen (30) des auf der Probenbühne (3) angeordneten Gegenstandes (1, 2) erhalten wird;

eine Lötstellenposition-Entnahmeeinrichtung (23, 24, 8), die eine Position jeder der Lötstellen (30) des zu prüfenden Gegenstandes (1, 2) in Übereinstimmung mit dem vom Röntgendetektor (5, 6) erfaßten röntgenfluoroskopischen Bildsignal entnimmt;

eine Prüfbereich-Setzeinrichtung (8), die in Übereinstimmung mit der entnommenen Position jeder Lötstelle, die von der Lötstellenposition-Entnahmeeinrichtung (23, 24, 8) entnommen worden ist, mehrere Prüfbereiche sowohl i) in einem Abschnitt einer Lötstelle als auch ii) in einem Umfangsabschnitt der Lötstelle (30) setzt, wobei die einzelnen Prüfbereiche jeder der Lötstellen entsprechen;

**gekennzeichnet durch**

eine Einrichtung zum Sammeln von röntgenfluoroskopischen Bildsignalformen $GW_i$ bis $GW_M$, die aus vielen guten Lötstellen erhalten werden, die im voraus als gute Lötstellen beurteilt worden sind;

eine Einrichtung, die die Lötstellen mit untereinander ähnlichen Formen in mehrere Klassen unterteilt, wobei eine Klasse durch Häufen vieler gesammelter röntgenfluoroskopischer Bildsignalformen $GW_1$ bis $GW_M$ geschaffen wird;

eine Einrichtung, die die typischen röntgenfluoroskopischen Bildformen $S_1$ bis $S_N$ aus den röntgenfluoroskopischen Bildformen jeder der unterteilten Klassen entnimmt;

eine Einrichtung, die mehrere Referenzsignalformen $S_1$ bis $S_N$ schafft, die den Formschwankungen der guten Lötstellen entsprechen;

eine Einrichtung, die jede der mehreren vorbereiteten Referenzbildsignalformen $S_1$ bis $S_N$ mit der röntgenfluoroskopischen Bildsignalform W im Prüfbereich an der zu prüfenden Lötstelle (30) vergleicht, und

eine Einrichtung, die einen Defekt der Lötstelle anzeigt, wenn der Wert $|W - S_j|$, $j = 1, ..., N$ einen vorgegebenen Referenzwert übersteigt oder diesem gleich ist.

17. Vorrichtung nach Anspruch 16,

bei der die Lötstellenposition-Entnahmeeinrichtung eine Einrichtung (23, 24, 8) enthält, die i) eine Position einer Anschlußleitung (32, 32') in einer j-Richtung einer Anschlußleitungsspitze durch eine horizontale Verteilungsprojektion mit einem in einer Anschlußleitungsreihen-Richtung projizierten röntgenfluoroskopischen Bildsignal entnimmt und ii) eine Position einer Anschlußleitung in einer Reihenrichtung durch eine vertikale Verteilungsprojektion mit dem röntgenfluoroskopischen Bildsignal in einer i-Richtung der Anschlußleitungsspitze entnimmt.

18. Vorrichtung nach Anspruch 16,

bei der die Defekt-Erfassungeinrichtung (8, 25, 26) eine Einrichtung enthält, die einen Defekt einer abweichenden Anschlußleitung (fehlausgerichteten Anschlußleitung) dadurch erfaßt, daß sie wenigstens entweder die Breite oder den Abstand der Lötstelle (30), die aus dem röntgenfluoroskopischen Bildsignal für jeden der gesetzten Lötabschnitt-Prüfbereiche erfaßt werden, mit einem Referenzwert vergleicht.

19. Vorrichtung nach Anspruch 16,

bei der die Defekt-Erfassungeinrichtung (8, 25, 26) eine Einrichtung enthält, die einen LötmittelmengenDefekt erfaßt, indem eine Lötmittelmenge an jeder von mehreren Lötstellen durch Integrieren des röntgenfluoroskopischen Bildsignals für jeden gesetzten Lötabschnitt-Prüfbereich ausgewertet wird.

20. Vorrichtung nach Anspruch 16,

bei der die Defekt-Erfassungeinrichtung (8, 25, 26) eine Einrichtung enthält, die den Defekt zwischen jeder von mehreren Lötstellen in Übereinstimmung mit einem binären Bild erfaßt, das aus dem röntgenfluoroskopischen Bildsignal für jeden gesetzten Prüfbereich des Umfangsabschnitts zwischen den mehreren Lötstellen umgewandelt wird.

21. Vorrichtung nach Anspruch 16,

bei der der Röntgendetektor ferner eine Einrichtung (7) enthält, mit der ein röntgenfluoroskopisches Bild in der Weise erhalten wird, daß innere und äußere Lötstellen von auf beiden Oberflächen des Substrats angebrachten elektrischen Teilen nicht überlagert sind.

22. Vorrichtung nach Anspruch 21,

bei der die Prüfbereich-Setzeinrichtung eine Einrichtung enthält, die für die mehreren Prüfbereiche zusammenfassend eine Menge von inneren und äußeren Lötstellen setzt.

23. Vorrichtung nach Anspruch 22,

bei der die Prüfbereich-Setzeinrichtung ferner eine Einrichtung enthält, die jeden der Prüfbereiche des einer Lötstelle entsprechenden röntgenfluoroskopischen Bildes in zwei Prüfbereiche unterteilt, die zwei Teilen entsprechen, wobei ein Fehler innerhalb von einem Fehler außerhalb getrennt werden kann.

24. Vorrichtung nach Anspruch 16,

ferner mit einer logarithmischen Umwandlungseinrichtung (12), die das aus dem Röntgendetektor (5, 6) erhaltene röntgenfluoroskopische Bildsignal einer Umwandlung mit natürlichem Logarithmus unterwirft, um das röntgenfluoroskopische Bildsignal zu erhalten.

**25.** Vorrichtung nach Anspruch 16,

bei der die Defekt-Erfassungeinrichtung ferner eine Einrichtung enthält, die mehrere Referenzbildsignalformen einer guten Lötstelle vorbereitet.

**26.** Vorrichtung nach Anspruch 16,

bei der die Defekt-Erfassungeinrichtung ferner eine Vergleichseinrichtung enthält, die einen Vergleich zwischen der röntgenfluoroskopischen Bildsignalform und der Referenzbildsignalform einer guten Lötstelle vornimmt, indem sie jedes durch den Vergleich erzeugte Differenzbildsignal integriert.

**27.** Vorrichtung nach Anspruch 16,

ferner mit einer Dreheinrichtung (7), die die optischen Achsen der Röntgenquelle (4) und des Röntgendetektors (5, 6) dreht, um den zu prüfenden Gegenstand relativ zu neigen.

**28.** Vorrichtung nach Anspruch 16,

bei der der Röntgendetektor (5, 6) eine Neigungseinrichtung enthält, die den zu prüfenden Gegenstand relativ neigt.

**29.** Vorrichtung nach Anspruch 16,

ferner mit einer Abschirmungseinrichtung (301, 311), die die Röntgenbeschädigung des Gegenstandes verringert.

**30.** Vorrichtung nach Anspruch 16,

bei der die Defekt-Erfassungeinrichtung versehen ist mit einer Einrichtung, die das röntgenfluoroskopische Bildsignal in ein binäres Bildsignal umwandelt, indem sie einen Schwellenwert verwendet, der der Aktualisierung lediglich des Lötmittels für jeden von der Bereichssetzeinrichtung gesetzten Prüfbereich im Umfangsabschnitt der Lötstelle (30) dient, und mit einer Signalvergleichseinrichtung, die das umgewandelte binäre Bildsignal und ein binäres Bildsignal einer guten Lötstelle vergleicht, um wenigstens eine Lötbrücke oder eine Lötkugel zwischen den Anschlußleitungen (32, 32') zu erfassen, wenn auf ein röntgenfluoroskopisches Bildsignal eines normalen Bereichs zwischen den Anschlußleitungen Bezug genommen wird.

**31.** Vorrichtung nach Anspruch 16,

ferner mit einer Einrichtung, die eine Anzahl von Mustern des binären Bildsignals und binäre Bildsignale einer guten Lötstelle vergleicht.

## Revendications

**1.** Procédé pour inspecter un joint soudé (30) pour être utilisé avec un dispositif de formation d'images fluoroscopiques à rayons X (4,5,6,7), le procédé comprenant les étapes consistant à :

obtenir un signal d'image fluoroscopique par irradiation, au moyen de rayons X, d'un objet à inspecter (1,2) et qui est situé sur une table porte-échantillon (3) et est formé par soudage d'un conducteur (32,32') d'un composant électronique (1) sur un substrat (2) au niveau dudit joint soudé (30),

extraire une position dudit joint soudé (30) dudit objet à inspecter (1,2), à partir dudit signal d'image fluoroscopique à rayons X obtenu,

définir, à partir du signal d'image fluroscopique à rayons X, une pluralité de zones d'inspection sur une partie de soudure et une partie périphérique du joint soudé (30) en fonction de la position extraite dudit joint soudé (30),

caractérisé par les étapes supplémentaires consistant à :

collecter des formes GW1 à GMm de signaux d'images fluoroscopiques à rayons X, obtenues à partir d'un grand nombre de bons joints soudés évalués par avance comme étant de bons joints soudés; répartir les joints soudés possédant des formes qui se ressemblent, en une pluralité de classes comme une classe par regroupement d'un grand nombre de formes GW1 à GWm de signaux d'images fluoroscopiques à rayons X, collectées; extraire des formes typiques S1 à SN d'images fluoroscopiques à rayons X à partir de la forme du signal d'image fluoroscopique à rayons X de chacune desdites classes séparées, et préparer une pluralité de formes de référence S1 à SN de signaux d'images correspondant aux variations de forme des bons joints soudés;

comparer chaque forme faisant partie d'une pluralité de formes de référence S1 à SN desdits signaux d'images préparés, avec la forme W du signal d'image fluoroscopique à rayons X, obtenue à partir

21

de l'inspection du joint soudé à inspecter (30), et indiquer un défaut dans ledit joint soudé (30) lorsque la valeur min$|W - Sj|$, j = 1, ..., N dépasse ou égale une référence prédéterminée.

2. Procédé selon la revendication 1,

dans lequel l'étape d'extraction inclut ladite position du joint soudé (30) par extraction
i) d'une position d'un conducteur (32,32') dans une direction j de la pointe du conducteur au moyen d'une projection horizontale de distribution avec ledit signal d'image fluoroscopique à rayons X projeté dans la direction d'une rangée de conducteurs, et
ii) d'une position d'un conducteur dans une direction de lignes au moyen d'une projection verticale de distribution avec ledit signal d'image fluoroscopique à rayons X projeté dans une direction i de la pointe du conducteur.

3. Procédé suivant la revendication 1, comprenant en outre l'étape consistant un défaut d'un conducteur dévié, c'est-à-dire d'un conducteur désaligné, par comparaison d'au moins une largeur isn - ien, (n= 1-4) et d'un espacement ien - isn+1 du joint soudé (30) détecté à partir dudit signal d'image fluoroscopique à rayons X pour chacune desdites zones d'inspection définie d'une partie de soudure à une valeur de référence.

4. Procédé selon la revendication 1,

comprenant en outre la détection d'un défaut d'une quantité de soudure par évaluation d'une quantité de soudure en chacun d'une pluralité de joints soudés (30) par intégration du signal d'image fluoroscopique à rayons X pour chacune desdites zones d'inspection définies de la partie de soudure.

5. Procédé selon la revendication 1,

dans lequel l'étape de détection comprend la détection dudit défaut entre chacun d'une pluralité de joints soudés (30) en fonction d'une image binaire obtenue par conversion à partir du signal d'image fluoroscopique à rayons X pour chacune desdites zones d'inspection définies de ladite partie périphérique entre la pluralité de joints soudés.

6. Procédé selon la revendication 1,

comprenant en outre les étapes consistant à incliner de façon relative lesdits rayons X et un objet à inspecter (1, 2), ce qui a pour effet que les joints soudés intérieur et extérieur (30,30) comportant des composants électroniques (1,1) montés respectivement sur les deux surfaces dudit substrat (2) ne sont pas superposés, pour l'obtention dudit signal d'image fluoroscopique à rayons X.

7. Procédé selon la revendication 6,

dans lequel l'étape de définition inclut la définition collective d'un ensemble de joints soudés intérieur et extérieur en tant que ladite pluralité de zones d'inspection.

8. Procédé selon la revendication 1,

dans lequel une pluralité de formes de signaux d'image de référence d'un bon joint soudé (30) sont préparés pour l'obtention de ladite forme de signal d'image de référence d'un bon joint soudé.

9. Procédé selon la revendication 1,

dans lequel ladite étape de comparaison inclut une comparaison entre ladite forme de signal d'image fluoroscopique à rayons X et la forme de signal d'image de référence d'un bon joint soudé par intégration de chaque signal d'image de différence fourni par ladite comparaison, et dans lequel ledit procédé comprend une étape consistant à déterminer la qualité d'un joint soudé au moyen d'un minimum de ladite valeur intégrée de ladite différence.

10. Procédé selon la revendication 1,

comprenant en outre l'actualisation uniquement de la soudure pour chaque zone d'inspection sur la partie périphérique du joint soudé (30) moyennant l'utilisation d'un seuil pour convertir le signal d'image fluoroscopique à rayons X en un signal d'image binaire, et la comparaison dudit signal d'image binaire actualisé et d'un signal d'image binaire d'un bon joint soudé pour détecter au moins un pont de soudure et une bille de soudure, présent entre les conducteurs (32,32') par rapport à un signal d'image fluoroscopique à rayons X d'une zone normale entre lesdits conducteurs.

11. Procédé selon la revendication 1,

dans lequel l'étape d'extraction inclut l'utilisation d'une configuration préaménagée dans ledit composant électronique (1) en tant que référence de position.

12. Procédé selon la revendication 1,

dans lequel l'étape d'extraction inclut l'utilisation d'une configuration préaménagée (41,42,43,44) formée sur ledit substrat (2) en tant que référence de position.

13. Procédé selon la revendication 1,

comprenant en outre l'obtention de ladite forme de signal d'image de référence de bons joints soudés à partir d'une forme de signal d'image fluoroscopique à rayons X d'un bon joint soudé typique.

14. Procédé selon la revendication 13,

comprenant en outre l'obtention de la forme de signal d'image fluoroscopique à rayons X desdits bons joints soudés typiques par regroupement de signaux de bons joints soudés par rapport à des images fluoroscopiques à rayons X d'un nombre de bons joints soudés.

15. Procédé selon la revendication 1,

comprenant en outre l'utilisation d'un signal d'image soumis à une conversion en algorithme naturel par rapport à l'image fluoroscopique à rayons X en tant que ledit signal d'image fluoroscopique à rayons X.

16. Dispositif pour inspecter un joint soudé (20) en utilisant une image fluoroscopique à rayons X, le dispositif comprenant :

des moyens (4) pour projeter des rayons X produits par une source de rayons X;

une table porte-échantillon (3) pour positionner un objet à inspecter (1,2) comprenant un conducteur (32,32') d'un composant électronique (1) soudé sur un substrat (2);

un détecteur de rayons X (5,6) pour détecter une image fluoroscopique à rayons X obtenue par transmission desdits rayons X à travers des joints soudés (30) de l'objet (1,2) positionné par ladite table porte-échantillon (3);

des moyens (23,24,8) d'extraction de la position de joints soudés pour extraire une position de chacun des joints soudés (30) dudit objet à inspecter (1,2), en fonction dudit signal d'image fluoroscopique à rayons X, détecté par ledit détecteur de rayons X (5,6);

des moyens (8) de positionnement de zones d'inspection pour positionner une pluralité de zones d'inspection à la fois sur i) une partie d'un joint soudé, et ii) une partie périphérique d'un joint soudé (30), correspondant à chacun des joints soudés en fonction de la position extraite de chaque joint soudé, qui est extraite par lesdits moyens (23,24,8) d'extraction de la position des joints soudés;

caractérisé par

des moyens pour collecter des formes GW1 à GWM de signaux d'images fluoroscopiques à rayons X, obtenues à partir d'un grand nombre de bons joints soudés évalués par avance comme étant de bons joints soudés;

des moyens pour répartir les joints soudés en une pluralité de classes constituant une classe par regroupement de nombreuses formes collectées GW1 à GWM de signaux d'images fluoroscopiques à rayons X;

des moyens pour extraire les formes typiques S1 à SN d'images fluoroscopiques à rayons X parmi les formes d'images fluoroscopiques à rayons X de chacune de classes séparées;

des moyens pour préparer une pluralité de formes de référence S1 à SN de signaux d'images correspondant aux variations de forme des bons joints soudés;

des moyens pour comparer chacune d'une pluralité desdites formes de référence préparées S1 à SN de signaux d'images à la forme W du signal d'image fluoroscopique à rayons X dans la zone d'inspection au niveau du joint soudé à inspecter (30), et

des moyens pour indiquer un défaut dans ledit joint soudé lorsque la valeur $|W - Sj|$ (j= 1,...,N) dépasse ou est égale à une référence prédéterminée.

17. Dispositif selon la revendication 16,

dans lequel lesdits moyens d'extraction de la position de joints soudés comprennent des moyens (23,24,8) pour i) extraire une position d'un conducteur (32,32') dans une direction j de la pointe du conducteur au moyen d'une direction de distribution horizontale, avec ledit signal d'image fluoroscopique à rayons X projeté dans une direction de ligne du conducteur, et ii) extraire une position d'un conducteur dans une direction de ligne au moyen d'une projection de distribution verticale avec ledit signal d'image fluoroscopique à rayons X dans une direction i de la pointe du conducteur.

18. Dispositif selon la revendication 16,
dans lequel lesdits moyens (8,25,26) de détection de défauts comprennent des moyens pour détecter un défaut d'un conducteur dévié (conducteur désaligné), comparaison d'au moins une largeur et d'un espacement du joint soudé (30) détecté à partir dudit signal d'image fluoroscopique à rayons X pour chacune desdites zones fixées d'inspection d'une partie de soudure, à une valeur de référence.

19. Dispositif selon la revendication 16,
dans lequel lesdits moyens (8,25,26) de détection de défauts comprennent des moyens pour détecter un défaut d'une quantité de soudure au moyen de l'évaluation d'une quantité de soudure en chacun d'une pluralité de joints soudés, par intégration du signal d'image fluoroscopique à rayons X pour chacune desdites zones d'inspection fixées de la partie de soudure.

20. Dispositif selon la revendication 16,
dans lequel lesdits moyens (8,25,26) de détection de défauts comprennent des moyens pour détecter ledit défaut entre chacun d'une pluralité de joints soudés en fonction d'une image binaire obtenue par conversion à partir du signal d'image fluoroscopique à rayons X pour ladite zone fixée d'inspection de ladite périphérique entre la pluralité de joints soudés.

21. Dispositif selon la revendication 16,
dans lequel ledit détecteur de rayons X comprend en outre des moyens (7) pour obtenir une image fluoroscopique à rayons X de sorte que des joints soudés intérieurs et extérieurs équipés de composants électriques montés respectivement sur les deux faces dudit substrat ne sont pas superposés.

22. Dispositif selon la revendication 21,
dans lequel lesdits moyens de détermination des zones d'inspection comprennent des moyens pour déterminer collectivement un ensemble de joints soudés intérieurs et extérieurs pour constituer ladite pluralité de zones d'inspection.

23. Dispositif selon la revendication 22,
dans lequel lesdits moyens de détermination de zones d'inspection comprennent en outre des moyens pour diviser chacune de zones d'inspection de l'image fluoroscopique à rayons X correspondant à un joint soudé en deux zones d'inspection correspondant à deux parties, ce qui permet de séparer le défaut de l'intérieur et de l'extérieur.

24. Dispositif selon la revendication 16, comprenant en outre des moyens de conversion logarithmique (13) servant à soumettre ledit signal d'image fluoroscopique à rayons X fourni par ledit détecteur de rayons X (5,6) à une conversion en un logarithme naturel, en tant que signal d'image fluoroscopique à rayons X.

25. Dispositif selon la revendication 16,
dans lequel lesdits moyens de détection de défauts comprennent en outre des moyens pour préparer une pluralité de formes de référence de signaux d'image d'un bon joint soudé.

26. Dispositif selon la revendication 16,
dans lequel lesdits moyens de détection de défauts comprennent en outre des moyens comparateurs pour effectuer une comparaison entre ladite forme du signal d'image fluoroscopique à rayons X et la forme de référence des signaux d'images d'un bon joint soudé, par intégration de chaque signal d'image de différence fourni par ladite comparaison.

27. Dispositif selon la revendication 16,
comprenant en outre des moyens d'entraînement en rotation (7) pour faire tourner les axes optiques de ladite source de rayons X (4) et dudit détecteur de rayons X (5,6) pour incliner de façon relative ledit objet à inspecter.

28. Dispositif selon la revendication 16,
dans lequel ledit détecteur de rayons X (5,6) comprend des moyens d'inclinaison pour incliner de façon relative ledit objet à inspecter.

24

29. Dispositif selon la revendication 16,

comprenant en outre des moyens de blindage (301, 311) pour réduire un endommagement de l'objet par les rayons X.

30. Dispositif selon la revendication 16,

dans lequel lesdits moyens de détection de défauts comprennent des moyens pour convertir ledit signal d'image fluoroscopique à rayons X en un signal d'image binaire moyennant l'utilisation d'un seuil pour actualiser uniquement la soudure pour chaque zone d'inspection sur la partie périphérique du joint soudé (30) fixée par lesdits moyens de détermination de zones, et des moyens de comparaison de signaux binaires pour comparer ledit signal d'image binaire converti et un signal d'image binaire d'un bon joint soudé pour détecter au moins un pont de soudure et une bille de soudure, présent entre les conducteurs (32, 32') en rapport avec un signal d'image fluoroscopique à rayons X d'une zone normale située entre lesdits conducteurs.

31. Dispositif selon la revendication 16, comprenant en outre des moyens pour comparer un nombre de configurations dudit signal d'image binaire et desdits signaux d'images binaires d'un bon joint soudé.

# FIG. 1

# FIG. 2

26

## FIG. 3

(a)

(b)

(c)

(d)

(e)

## FIG. 4

(a)

(b)

(c)

(d)

## FIG. 5

(a) (b) (c) (d) (e)

FIG. 6

FIG. 7a

FIG. 7b

FIG. 7c

FIG. 8

EP 0 407 685 B1

## FIG. 9

```
15    g(i,j)
DETCTING IMAGE ─────────────────────┐
                                     ▼
16  ┌──────────┐  B(i,j)      ┌──────────┐
    │ BLACK    │─────────────▶│ SUB-     │ g-B
    │ IMAGE    │         ●────│ TRACTER  │────┐
    │ MEMORY   │         │    └──────────┘    │   ┌─────────┐      ┌──────────────┐
    └──────────┘         │         18         ├──▶│ COM-    │─────▶│ MEMORY       │ 21
                         │                    │   │ BINER   │      │ FOR TRANS-   │
17  ┌──────────┐  W(i,j) │    ┌──────────┐    │   └─────────┘      │ FORMATION    │
    │ WHITE    │─────────┴───▶│ SUB-     │────┘       20           │ TABLE        │
    │ IMAGE    │              │ TRACTER  │ W-B                     └──────────────┘
    │ MEMORY   │              └──────────┘                              │ 22
    └──────────┘                   19                                   ▼
                                                                      f(i,j)
```

## FIG. 10

```
         i1                    i2
         │                     │        i
  ┌──────┼─────────────────────┼───────▶
  │      ╎                     ╎
  │      ╎                     ╎
j1┤ ─ ─ ─┌─────────────────────┐
  │      │/////////////////////│
  │      │/////////////////////│
j2┤ ─ ─ ─└─────────────────────┘
  │
  │
  ▼
  j
```

## FIG. 11

```
       32    33
        │    │            32
      ┌─┴────┴──────────┐ │
      └──┬─┬─┬─┬─┬──────┘
    ━━━━━━━━━━━━━━━━━━━━━━━
        │            │
       30            2
```

FIG. 12a

FIG. 12b

FIG. 13a

FIG. 13b

BRIGHTNESS

POSITION

## FIG. 14a

PROJECT DIRECTION

## FIG. 14b

BRIGHTNESS

H(j)

j

POSITION

## FIG. 15

BRIGHTNESS H (j)

H(j)

Th₁

js        je        j

## FIG. 16a

PROJECT DIRECTION

js

je

## FIG. 16b

BRIGHTNESS

V(i)

i

# FIG. 17

# FIG. 18

# FIG. 19

# FIG. 20a

BRIGHTNESS

# FIG. 20b

BRIGHTNESS

FIG. 21a₁

FIG. 21a₂

FIG. 21b₁ |

FIG. 21b₂ |

FIG. 21b₃

FIG. 21b₄

$$\frac{|(\ln I_{1,S} - \ln I_{1,0})|}{\mu_1}$$

FIG. 21c₁ ‖

FIG. 21c₂ ‖

FIG. 21c₃

FIG. 21c₄ ‖

$$|t_{1,0} - t_{1,S}|$$

FIG. 22

EP 0 407 685 B1

# FIG. 23

```
                    ┌──────────────────────┐  231
                    │     LOADING  PCB     │
                    └──────────────────────┘
                               │
                    ┌──────────────────────┐  232
                    │     LOCATING  PCB    │
                    └──────────────────────┘
                               │
                    ┌──────────────────────┐  233
                    │   X-RAY  IMAGE  INPUT │
                    └──────────────────────┘
                               │
                    ┌──────────────────────┐  234
                    │   ARE GOOD  SOLDER    │
                    │   JOINTS  FOUND ?     │─── YES
                    └──────────────────────┘
                             │ NO
                    ┌──────────────────────┐  235
                    │    UNLOADING  PCB    │
                    └──────────────────────┘
                               │
                    ┌──────────────────────┐  236
                    │  ARE COLLECTED DECIDED│─── NO
                    │  NUMBER  OF  IMAGE ?  │
                    └──────────────────────┘
                             │ YES
                    ┌──────────────────────┐  237
                    │  CLUSTERING  GOOD     │
                    │  SOLDER  JOINTS  IMAGE│
                    └──────────────────────┘
                               │
                    ┌──────────────────────┐  238
                    │  DETECTING  STANDARD  │
                    │  GOOD  SOLDER  JOINT  │
                    │  IMAGE                │
                    └──────────────────────┘
```

# FIG. 24

## (a)

## (b)

PROJECTION VALUE

Th3

i
POSITION

## (c)

i$_{s1}$  i$_{e1}$

*FIG. 25*

*FIG. 26*

(a)

(b)

*FIG. 27*

(a)

(b)

is1  ic1  ie1  is2  ic2  ie2  is3  ic3  ie3  is4  ic4  ie4

# FIG. 28

X-RAY IMAGE INPUT — 101

SHADING COMPENSATION — 102

LOGARITHMIC CONVERSION — 103

POSITION DETECTION IN THE DIRECTION OF LEAD TIP — 104

POSITION DETECTION IN THE DIRECTION OF LEAD ROW — 105

POSITION DETECTIC OF SOLDERING AREA

SOLDER QUANTITY DECISION — 106

MIS-ALIGNED LEAD DECISION — 107

BRIDGE DECISION — 108

FILLET SHAPE DECISION — 109

# FIG. 29

```
┌─────────────────────────────────┐
│     X-RAY IMAGE INPUT           │ ~101'
└─────────────────────────────────┘
                │
                ▼
┌─────────────────────────────────┐
│     SHADING COMPENSATION        │ ~102'
└─────────────────────────────────┘
                │
                ▼
┌─────────────────────────────────┐
│     LOGARITHMIC CONVERSION      │ ~103'
└─────────────────────────────────┘
                │
                ▼
┌─────────────────────────────────┐ ~104'
│  POSITION DETECTION IN THE      │         ┐
│  DIRECTION OF LEAD TIP          │         │
└─────────────────────────────────┘         │  POSITION
                │                            │  DETECTIC OF
                ▼                     ~105'  ├  SOLDERING
┌─────────────────────────────────┐         │  AREA
│  POSITION DETECTION IN THE      │         │
│  DIRECTION OF LEAD ROW          │         ┘
└─────────────────────────────────┘
         │                    │
         ▼                    ▼
┌──────────────────┐  ┌──────────────────┐
│ SOLDER QUANTITY  │  │ FILLET SHAPE     │
│ DECISION         │  │ DECISION         │
└──────────────────┘  └──────────────────┘
         106'                  109'
```

## FIG. 30

| | |
|---|---|
| NO TILTING PCB | ~110 |

| | |
|---|---|
| LOCATING PCB ACCORDING TO POSITION INFORMATION | ~111 |

| | |
|---|---|
| X-RAY IMAGE AND DEFECT DETECTION | ~112 |

NO — ARE ALL SOLDER JOINTS INSPECTED ? ~113

YES

| | |
|---|---|
| TILTING PCB | ~114 |

| | |
|---|---|
| LOCATING PCB ACCORDING TO POSITION INFORMATION | ~115 |

| | |
|---|---|
| X-RAY IMAGE AND DEFECT DETECTION | ~116 |

NO — ARE SOLDER JOINTS PHASE $F_1$ AND $F_3$ INSPECTED ? ~117

YES

| | |
|---|---|
| 90° ROTATION | ~118 |

| | |
|---|---|
| LOCATING PCB ACCORDING TO POSITION IMFORMATION | ~119 |

| | |
|---|---|
| X-RAY IMAGE AND DEFECT DETECTION | ~120 |

NO — ARE SOLDER JOINTS PHASE $F_2$ AND $F_4$ INSPECTED ? ~121

YES

| | |
|---|---|
| -90° ROTATION | ~122 |

| | |
|---|---|
| NO TILTING PCB | ~123 |

## FIG. 31

(a)

$(\theta = 0°)$

(b)

## FIG. 32

## FIG. 33

# FIG. 34

# FIG. 35

# FIG. 36

EP 0 407 685 B1

## FIG. 37

## FIG. 38

## FIG. 39a

## FIG. 40a

## FIG. 39b

## FIG. 40b

## FIG. 39c

## FIG. 40c

FIG. 41

FIG. 42a

FIG. 43a

FIG. 42b

FIG. 43b

FIG. 42c

FIG. 43c

FIG. 42d

FIG. 43d

## FIG. 44

## FIG. 45

## FIG. 46

# FIG. 47a

# FIG. 48a

# FIG. 49a

# FIG. 47b

# FIG. 48b

# FIG. 49b

# FIG. 47c

# FIG. 48c

# FIG. 49c

# FIG. 47d

# FIG. 48d

# FIG. 49d

FIG.. 50a

FIG. 50b

FIG. 50c

FIG. 51a

FIG. 51b

PROJECT DIRECTION

BRIGHTNESS

POSITION

POSITION

H(j)

FIG. 52

FIG. 53a

FIG. 53b

FIG. 54

FIG. 55a

235

ja

jb

Dw

ia1, ib1, ia2, ib2, ia3, ib3

FIG. 55b

j

FIG. 55c

PROJECTION VALUE

Vw

i

ΔW1  ΔW2  ΔW3  ΔW4

FIG. 56

43  45  44

41  48  48  48  48  42

46

# FIG. 57

(a)

(c)

(b)

# FIG. 58